# EUROPÄISCHE PATENTSCHRIFT

(11) **EP 4 602 509 B1**
(45) Veröffentlichungstag und Bekanntmachung des Hinweises auf die Patenterteilung: **02.12.2026**
(21) Anmeldenummer: 23792884.1
(22) Anmeldetag: 11.10.2023
(51) Int. Cl.: G06K 19/077, H10W 74/01, H10W 74/10

(54) **MODULTRÄGERBAND**
MODULE-CARRIER TAPE
BANDE SUPPORT DE MODULE

(30) Priorität: 12.10.2022 DE 102022003764
(43) Veröffentlichungstag der Anmeldung: 20.08.2025
(73) Patentinhaber: Giesecke+Devrient ePayments GmbH, 81677 München (DE)
(72) Erfinder: KLUGE, Stefan, 80997 München (DE)
(74) Vertreter: LKGLOBAL Partnerschaftsgesellschaft mbB
(86) Internationale Anmeldenummer: PCT/DE2023/100757
(87) Internationale Veröffentlichungsnummer: WO 2024/078665

(56) Entgegenhaltungen:
- DE-A1- 10 236 666
- DE-B3- 102006 044 525
- US-A1- 2006 289 979
- US-A1- 2012 000 065

## Beschreibung

Die vorliegende Erfindung betrifft ein Verfahren und eine Vorrichtung zum Aufbringen einer Kleberschicht auf ein mit einer Vielzahl von Chipmodulen versehenes Modulträgerband. Ferner betrifft die Erfindung eine entsprechende Kleberschicht sowie ein mit einer derartigen Kleberschicht versehenes Modulträgerband. Schließlich betrifft die Erfindung die Herstellung eines portablen Datenträgers ausgehend von einem erfindungsgemäßen Modulträgerband sowie einen entsprechenden portablen Datenträger.

Es ist bekannt, portable Datenträger, wie etwa Chipkarten oder Smartcards mit integrierten Schaltkreisen (ICs), Chips und/oder Mikroprozessoren auszustatten, um Benutzern elektronisch abgesicherte Funktionalitäten bereitzustellen, wie etwa die Möglichkeit, gesicherte Finanztransaktionen durchzuführen, Identitäten und Zugangsberechtigungen nachzuweisen oder dergleichen. Daneben können in portable Datenträger weitere elektronische Funktionseinheiten integriert sein, etwa Speicherchips, Antennen und Spulen oder Displays. Bei solchen portablen Datenträgern handelt es sich regelmäßig um Biometriekarten, Dual-Interface-Karten, Personalausweise, Geld- oder Kreditkarten, Schlüssel- oder Identitätskarten oder dergleichen.

Ergänzend sind solche portablen Datenträger zur Identifizierbarkeit und verbesserten Fälschungssicherheit häufig mit Sicherheitsmerkmalen ausgestattet, zum Beispiel in Form von Buchstaben oder Zahlen, Prägestrukturen, optisch variablen Linsen- oder Gitterstrukturen, oder dergleichen.

Bei der Serienherstellung solcher Datenträger werden deren Chips in Form von sogenannten Chipmodulen in passgenaue Kavitäten der entsprechenden Datenträgerkörper eingesetzt und mit den im Datenträgerkörper eingebetteten elektronischen Strukturen kontaktiert, etwa mit Spulen, Antennen, Sensoren, Displays oder dergleichen.

Dazu werden zunächst Modulträgerbänder mit einer Vielzahl darauf regelmäßig angeordneten Chipmodulen bereitgestellt, auf die eine mit Kontaktaussparungen versehene Kleberschicht derart präzise aufgebracht wird, dass diese die Kontakte der Chipmodule für die spätere Kontaktierung freilassen. Die anschließend vereinzelten Chipmodule werden dann mittels der darauf aufgebrachten Kleberschichtabschnitte in die Kavitäten der Datenträgerkörper derart eingeklebt, dass die Oberseite des Modulträgers mit der Oberfläche des Datenträgerkörpers im Wesentlichen abschließt.

Anders als die flächige Kleberschicht hat ein derartiges Modulträgerband aufgrund der erhabenen Chipmodule eine dreidimensionale Höhen-/Tiefenstruktur, die zwischen den erhöhten Oberflächen der Chipmodule und den diese umschließenden, tieferliegenden Basisbereichen des Modulträgerbands variiert. Die gesamte zu überspannende Oberfläche des Modulträgerbands ist deshalb größer als die Grundfläche der darauf aufzubringenden flächigen Kleberschicht.

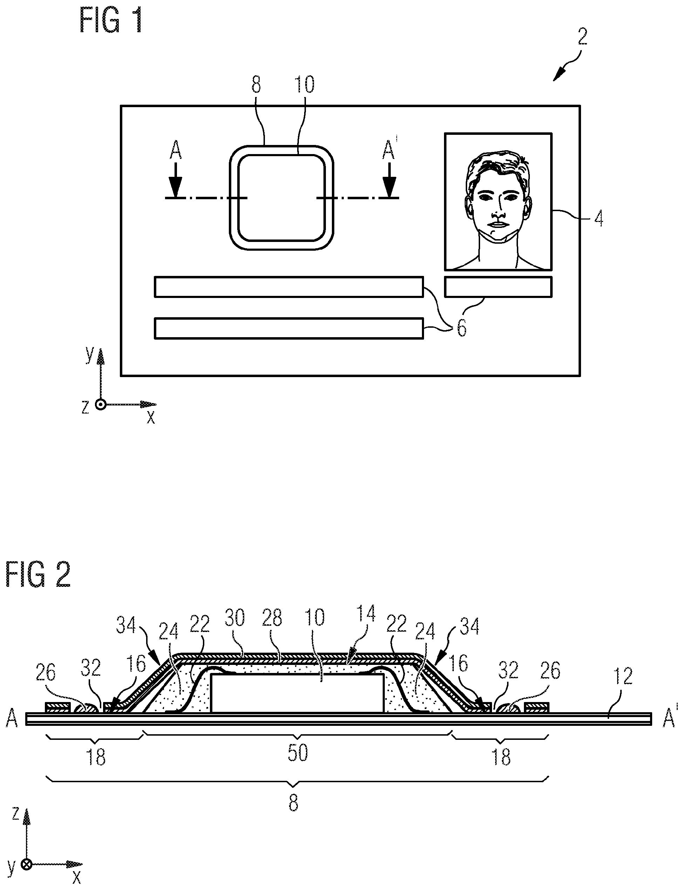

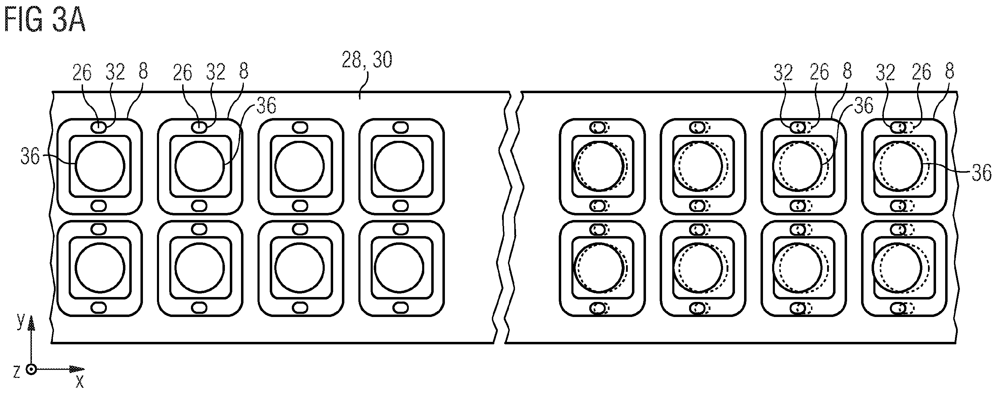

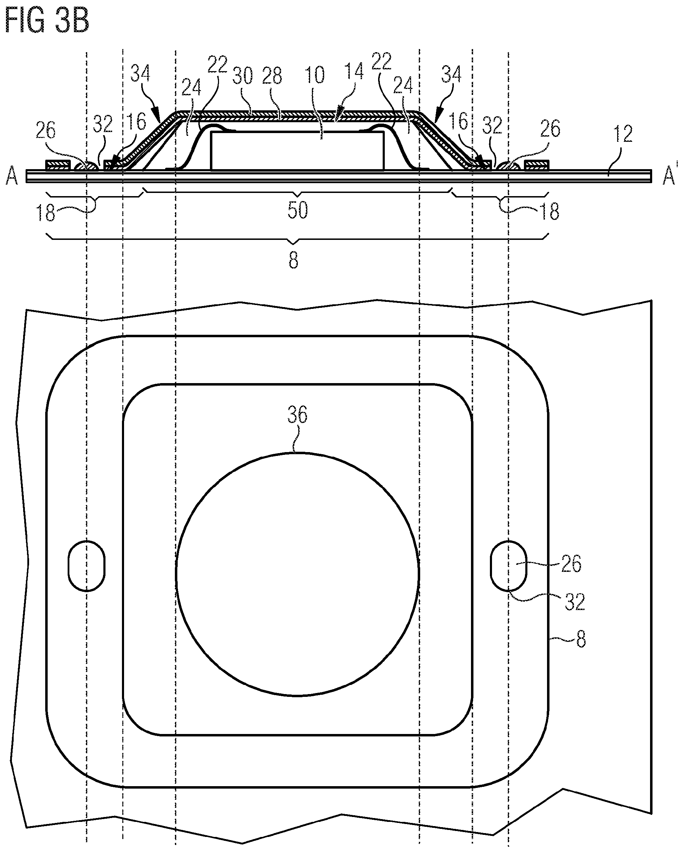

Wie in Fig. 3A illustriert, kann es deshalb vorkommen, dass beim Aufbringen einer Kleberschicht 28, zum Beispiel indem diese von einer Rolle in Längsrichtung auf das Modulträgerband abgerollt wird, ein in Fig. 3A strichliniert angedeuteter, sich vergrößernder Versatz in Längsrichtung entsteht, der dazu führt, dass die anfänglich positionsgenau auf die Chipmodule 8 und deren Kontakte 26 abgestimmten Aussparungen 32, 36 der Kleberschicht 28 nach einigen Metern nicht mehr passen. Das Aussparen der kompletten Chipmodulfläche 8 in der Kleberschicht 28 durch zentrale, große Löcher 36 und das Aufbringen einer solchen Kleberschicht 28 nur auf die umliegenden Basisbereiche des Modulträgerbands ist prozesstechnisch problematisch, da dann die Kontaktaussparungen 32 der Kleberschicht 28 nicht mehr von genug Kleberschichtmaterial umschlossen werden, so dass die Kleberschicht 28 instabil wird und das Chipmodul 8 schließlich sogar wieder aus dem Datenkörperträger herausgelöst werden könnte. Die Fig. 3B verdeutlicht diese Problematik mittels der dimensionskorrekten Gegenüberstellung eines Abschnitts der Kleberschicht 28 der Fig. 3A und des Chipmoduls 8 der weiter unten beschriebenen Fig. 2.

US 2012 / 0 000 065 A1 beschreibt elektronische Bauteile, die jeweils ein Chipmodul mit Modulkontakten und eine Antenne mit Antennenkontakten umfassen, und hergestellt werden, indem eine Vielzahl von Chipmodulen auf der Innenseite eines Modulfolienstreifens befestigt wird, dessen Außenumfang über das Chipmodul hinausragt, wobei die Chipmodule in einem gleichmäßigen, vorgegebenen Modulabstand voneinander beabstandet sind. Mehrere Antennen sind an der Innenseite eines länglichen Antennenstreifens befestigt, wobei die Antennen durch einen vorbestimmten Antennenabstand voneinander beabstandet sind. Der Modulstreifen ist in Längsrichtung in Abschnitte unterteilt, von denen jeder eine Länge aufweist, die dem vorgegebenen Modulabstand entspricht, und von denen jeder ein entsprechendes Chipmodul trägt. Die Modulstreifenabschnitte werden so gegen den Antennenstreifen gepresst, dass die Modulkontakte jedes Chipmoduls mit den Antennenkontakten der jeweiligen Antenne in Eingriff kommen und diese berühren. DE 10 2006 044 525 B3 beschreibt ein Verfahren zur Herstellung von integrierten Schaltkreisen, die mechanisch flexibel sind und zusammenhängend auf einem gemeinsamen flexiblen Trägersubstrat bereitstellbar sind. Das Verfahren umfasst dabei einen Schritt des kontinuierlichen Bereitstellens eines ersten flexiblen Substrats, das Leiterbahnstrukturen aufweist, und einen Schritt des Anbringens der integrierten Schaltkreise an dem ersten flexiblen Substrat und Verbinden der integrierten Schaltkreise mit den Leiterbahnstrukturen des ersten flexiblen Substrats, und einen Schritt des Abdeckens der an dem ersten flexiblen Substrat angebrachten Schaltkreise mit einem zweiten flexiblen Substrat, wobei Ausnehmungen in dem ersten oder zweiten flexiblen Substrat vorgesehen sind, um die Leiterbahnstrukturen des ersten flexiblen Substrats zugänglich zu machen. Der Schritt des Abdeckens weist dabei den Unterschritt des kontinuierlichen Bereitstellens einer flexiblen Folie mit Ausnehmungen und Auflaminieren derselben auf den auf dem ersten flexiblen Substrat angebrachten, flexiblen integrierten Schaltkreisen, oder einen Unterschritt des drucktechnischen Aufbringens einer Abdeckung auf dem ersten flexiblen Substrat angebrachten, flexiblen integrierten Schaltkreisen auf.

Der Erfindung liegt daher die Aufgabe zugrunde, eine Lösung für die oben genannten technischen Probleme vorzuschlagen, die es ermöglicht, eine Kleberschicht positionsgenau auf ein mit einer Vielzahl von Chipmodulen ausgestattetes Modulträgerband aufzubringen, so dass Kontakte der vereinzelten Chipmodule freibleiben und eine ausreichend große Haftung gewährleistet ist.

Diese Aufgabe wird erfindungsgemäß durch das Verfahren gemäß Anspruch 1 gelöst. Eine entsprechende erfindungsgemäße Vorrichtung zum Aufbringen einer Kleberschicht auf ein Modulträgerband, ein mit einer Kleberschicht verbundenes Modulträgerband, eine erfindungsgemäße Kleberschicht sowie ein Verfahren zur Herstellung eines portablen Datenträgers und ein solcher Datenträger sind Gegenstand weiterer unabhängiger Ansprüche. Vorteilhafte Weiterbildungen der Erfindung sind in den Unteransprüchen angegeben.

Gemäß einem ersten Aspekt wird ein Verfahren zum Aufbringen einer Kleberschicht auf ein mit einer Vielzahl von Chipmodulen versehenes Modulträgerband bereitgestellt. Die mit der Kleberschicht versehenen, später vereinzelten Chipmodule werden in Sicherheitsdokumente eingebracht, etwas in kartenförmige Datenträger oder Sicherheitsdokumente in Blattform.

Das Modulträgerband ist flächig ausgebildet, es kann beispielsweise ein Filmtape umfassen. Das Modulträgerband ist in der Regel steif ausgestaltet, also im Wesentlichen undehnbar. Das Modulträgerband kann plan ausgebildet sein. Beispielsweise ist das Modulträgerband durchgehend flächig und/oder plan. Das Modulträgerband kann eine Dicke von mehr als 0.5 mm aufweisen, beispielsweise eine Dicke von einem oder mehreren Millimetern, insbesondere eine Dicke von 3.5 mm.

Auf dem Modulträgerband ist eine Vielzahl von Chipmodulen angeordnet, die chipförmige elektrische Bauteile bzw. Halbleiterstrukturen umfassen. Die Chipmodule und somit das Modulträgerband können Einkapselungen bzw. Schutzschichten oder weitere Schichten umfassen, welche die chipförmigen Bauteile jeweils bedecken oder/und einkapseln. Das Modulträgerband kann BondDrähte umfassen, die mit den jeweiligen chipförmigen Bauteilen verbunden sind. Auch die BondDrähte können von den Einkapselungen umschlossen sein.

Die Oberflächen der Chipmodule sind gegenüber den Oberflächen der jeweils umliegenden Basisbereiche des Modulträgerbands erhöht. Unter diesen umliegenden Basisbereichen des Modulträgerbands sind Bereiche des Modulträgerbands zu verstehen, die sich (z.B. in einer Draufsicht auf das Modulträgerband) um die Chipmodule herum erstrecken oder benachbart zu den Chipmodulen liegen und/ an die Chipmodule angrenzen. Die Oberflächen der Chipmodule können im Wesentlichen parallel und beabstandet zu der Oberfläche der umliegenden Basisbereiche des Modulträgerbands sein. Die Chipmodule können deshalb die Form von Höckern auf dem Modulträgerband aufweisen.

Das Verfahren umfasst einen Schritt des Ausbildens von einer oder bevorzugt mehreren Laschen in der Kleberschicht, indem die Laschen von umliegenden Bereichen der Kleberschicht gelöst oder getrennt werden. Unter den genannten umliegenden Bereichen der Kleberschicht sind diejenigen Bereiche der Kleberschicht zu verstehen, die nach dem Ausbilden der Laschen um diese herum oder benachbart zu diesen liegen oder/und Außenkanten der Laschen gegenüberstehen. Die Laschen können als Abschnitte in der Kleberschicht ausgebildet sein, die relativ zu der restlichen Kleberschicht bewegbar sind, z.B. abwinkelbar oder knickbar, ohne dass die Kleberschicht dabei gestreckt werden muss. Die Laschen können eine oder mehrere freie Kanten oder Außenkanten umfassen.

Die Laschen werden derart in der Kleberschicht ausgebildet, dass sie mit den Chipmodulen des Modulträgerbandes korrespondieren. Das heißt, die relativen Positionen der in der Kleberschicht ausgebildeten Laschen entsprechen den relativen Positionen der Chipmodule auf dem Modulträgerband, so dass die Laschen jeweils auf Chipmodulen zu liegen kommen, wenn die Kleberschicht mit dem Modulträgerband verbunden wird.

In diesem Sinne umfasst das erfindungsgemäße Verfahren ferner einen Schritt des Verbindens der Kleberschicht mit dem Modulträgerband derart, dass die Laschen jeweils (zumindest oder nur) auf den gegenüber dem Modulträgerband erhöhten Oberflächen der Chipmodule aufliegen. Entsprechend liegen die jeweils an die Laschen angrenzenden Abschnitte der Kleberschicht (nur) auf den Basisbereichen des Modulträgerbands auf. Auf diese Weise werden die angrenzenden Bereiche der Kleberschicht auf den Basisbereichen des Modulträgerbands befestigt und die Laschen werden gegebenenfalls jeweils auf den korrespondierenden Chipmodulen befestigt. Insbesondere wird das Entstehen eines Versatzes beim Abrollen in Längsrichtung im Wesentlichen vermieden, denn die Laschen gleichen die gegenüber der Grundfläche der Kleberschicht erhöhte überspannte Oberfläche des Modulträgerbands im Wesentlichen aus. Die Chipmodule und deren Kontakte bleiben auf diese Weise über die gesamte Länge passgenau auf die Aussparungen der Kleberschicht abgestimmt.

Zum Verbinden der Kleberschicht mit dem Modulträgerband wird die Kleberschicht vorzugsweise erwärmt. Bei der Kleberschicht kann es sich insofern um einen Heißkleber (Hotmelt) handeln. Zum Befestigen der Laschen auf den Oberflächen der Chipmodule können die Laschen auf die Chipmodul-Oberflächen aufgedrückt bzw. aufgepresst werden, etwa durch einen geeigneten wärmeleitenden Stempel. Entsprechend werden die angrenzenden Abschnitte der Kleberschicht mit den Basisbereichen des Modulträgerbands verbunden, indem auch diese aufgedrückt bzw. aufgepresst werden, etwa durch den gleichen wärmeleitenden Stempel.

Das Verfahren kann ferner einen Schritt des Ausbildens von Kontaktaussparungen in der Kleberschicht umfassen. Die Kontaktaussparungen werden derart in die Kleberschicht eingebracht, dass sie mit den elektrischen Kontakten der Chipmodule des Modulträgerbands korrespondieren. Beim Verbinden der Kleberschicht mit dem Modulträgerband umschließen die Kontaktaussparungen die elektrischen Kontakte der Chipmodule derart, dass die elektrischen Kontaktelemente unbedeckt bleiben und auch nach Aufbringen der Kleberschicht zugänglich sind und kontaktiert werden können.

Die Kontaktaussparungen sind ausschließlich in den weiteren Bereichen der Kleberschicht vorgesehen. Die Kontaktaussparungen können vollständig oder zumindest teilweise in den an die Laschen angrenzenden Abschnitte der Kleberschicht ausgebildet sein. Die Kontaktaussparungen schneiden beispielsweise keine Außenkanten der Lasche. Die Kontaktaussparungen stellen z.B. keine Außenkanten oder keine Abschnitte von Außenkanten der Laschen dar.

Über die elektrischen Kontaktelemente können die Chipmodule mit anderen Funktionselementen elektrisch verbunden werden, etwa mit Funktionselementen von portablen Datenträgern oder Sicherheitsdokumenten, in welche die vereinzelten Chipmodule später eingesetzt werden. Die elektrischen Kontaktelemente können Elektroden-Pads oder Anschlusselektroden sein. Auf dem Modulträgerband kann eine Vielzahl solcher elektrischer Kontaktelemente angeordnet sein, insbesondere zum Beispiel zwei, vier, sechs oder zehn elektrische Kontaktelemente pro Chipmodul. Die Kontaktelemente können um die jeweiligen Chipmodule herum angeordnet sein, zum Beispiel symmetrisch in einer Aufsicht auf das Modulträgerband. Vorzugsweise ist für jedes dieser elektrischen Kontaktelemente in der Kleberschicht eine Kontaktaussparung ausgebildet, die beim Verbinden der Kleberschicht mit dem Modulträgerband auf dem betreffenden Kontaktelement angeordnet wird, sodass dieses von der Kleberschicht unbedeckt bleibt.

Die Laschen können mittels des Einbringens von Aussparungen in der Klebeschicht ausgebildet werden. Gemäß einer bevorzugten Ausgestaltung der Erfindung werden die Laschen mittels des Einbringens von Schnittmustern in der Klebeschicht ausgebildet. Auf diese Weise bilden Schnittmuster jeweils die Laschen und deren angrenzende Abschnitte in der Kleberschicht derart, dass sich die Schnittmuster beim Verbinden der Kleberschicht mit dem Modulträgerband zu Aussparungen aufweiten, damit die Kleberschicht auch auf Flanken der Chipmodule aufliegen kann, welche die Übergänge von den erhöhten Oberflächen der jeweiligen Chipmodule zur Oberfläche der Basisbereiche des Modulträgerbands bilden. Die an die Laschen angrenzenden Abschnitte der Kleberschicht liegen dann auf den Basisbereichen des Modulträgerbands auf und das Aufweiten der Schnittmuster zu sichtbaren Aussparungen schafft eine Flexibilität bzw. einen Materialüberschuss der Kleberschicht, der er erlaubt, dass die Kleberschicht neben den Oberflächen der Chipmodule und den Basisbereichen des Modulträgerbandes auch die Flanken der Chipmodule bedeckt.

Die Flanken der Chipmodule können hierbei mit einem Teil der Laschen bedeckt werden, während bzw. weil sich die Schnittmuster zu Aussparungen aufweiten. Die aufgrund der erhöhten Chipmodule größere Oberfläche des Modulträgerbands im Vergleich zur Kleberschicht kann also erfindungsgemäß vollständig mit der Kleberschicht bedeckt werden, da sich beim Verbinden der Kleberschicht mit dem Modulträgerband entlang der Schnittmuster Aussparungen aufweiten, die die größere Oberfläche des Modulträgerbands kompensieren.

Die Schnittmuster können vorteilhaft insbesondere derart in die Kleberschicht eingebracht werden, dass die betreffenden Aussparungen solche Bereiche der Chipmodule freigeben, die etwa aus thermischen, sensorischen oder anderweitigen elektrischen Gründen freigehalten werden sollen. Diese Aussparungen können auch mechanische Spannungen in der Kleberschicht minimieren.

Vorzugsweise wird die Kleberschicht also derart mit dem Modulträgerband verbunden, dass von der Kleberschicht nur die Laschen auf den Oberflächen der jeweiligen Chipmodule aufliegen und diese beispielsweise im Wesentlichen vollständig bedecken. Alternativ oder zusätzlich können die Laschen auch auf den Flanken der betreffenden Chipmodule aufliegen, also auf den Übergängen von den erhöhten Chipmodul-Oberflächen zur Oberfläche der Basisbereiche des Modulträgerbands.

Auf diese Weise liegt die Kleberschicht erfindungsgemäß vollflächig auf dem Modulträgerband auf, weil die Laschen bzw. die entsprechenden Schnittmuster es der Kleberschicht ermöglichen, sich an die erhöhten Chipmodule anzupassen, ohne dass diese Falten wirft oder gestreckt wird oder Fehlpositionierungen der Kleberschicht auf dem Modulträgerband auftreten.

Die Kleberschicht kann auf einer Trägerfolie angeordnet sein, welche in Rollenform vorliegen und vor dem Ausbilden der Laschen abgerollt werden kann. Die Trägerfolie kann nach dem Verbinden der Kleberschicht mit dem Modulträgerband zunächst auf der Kleberschicht verbleiben und zumindest temporär als Abdeckschicht dienen.

Vorzugsweise umfasst das Verfahren jedoch einen Schritt des Abziehens der Trägerfolie von der Kleberschicht nach dem Verbinden der Kleberschicht mit dem Modulträgerband, um die Kleberschicht freizugeben. Die Kleberschicht kann als Heißkleberband (Hotmelt-Band) ausgebildet sein. Die Kleberschicht oder/und die Trägerfolie ist vorzugsweise undehnbar bzw. im Wesentlichen undehnbar. Die Kleberschicht kann mittels Wärmetransfer mit dem Modulträgerband und den Chipmodulen verbunden werden.

Die Ausgestaltung der Kleberschicht als Transferschicht erlaubt es, eine sehr dünne Kleberschicht vorzusehen. Auch kann auf diese Weise ein zuverlässiges Ausbilden der Laschen sichergestellt werden, da die Kleberschicht bei dem Ausbilden der Laschen auf der Trägerfolie angeordnet ist oder/ und von der Trägerfolie gestützt wird.

Die Trägerfolie kann beginnend mit einem in Abziehrichtung hinten liegenden Abschnitt des Modulträgerbands in Richtung eines in Abziehrichtung vorne liegenden Abschnitts des Modulträgerbands abgezogen werden, beispielsweise nachdem die als Transferschicht ausgestaltete Kleberschicht mit dem Modulträgerband verbunden wurde. Die Trägerfolie wird auf diese Weise von der Kleberschicht abgezogen bzw. störungsfrei getrennt.

Die auf den Chipmodulen aufliegenden Laschen können mit ihren distalen bzw. freien Enden in jeweils vorbestimmte Richtungen weisen. Unter einer vorbestimmten Richtung ist in diesem Zusammenhang eine Richtung zu verstehen, die ausgehend von dem an die Laschen angrenzenden Abschnitte der Kleberschicht zu dem jeweils distalen bzw. freien Ende der Laschen weist. Ein distales oder freies Ende ist in diesem Zusammenhang beispielsweise ein von dem an die betreffende Lasche angrenzenden Abschnitt der Kleberschicht abgewandtes und/oder beabstandetes Ende der Lasche.

Die vorbestimmten Richtungen der distalen Enden der Laschen erfüllen beispielsweise jeweils eine der folgenden Bedingungen: (i) die vorbestimmte Richtung ist orthogonal zu der Abziehrichtung; (ii) die vorbestimmte Richtung verläuft in einem spitzen Winkel zur Abziehrichtung; (iii) die vorbestimmte Richtung entspricht der Abziehrichtung.

Die Trägerfolie wird zum Beispiel zuerst von den an die Laschen angrenzenden Abschnitten der Kleberschicht abgezogen und danach von den Laschen selbst abgezogen. Von den distalen Enden der Laschen wird die Trägerfolie beispielsweise erst abgezogen, nachdem sie von den restlichen Bereichen der Laschen abgezogen wurde. Das Abziehen der Trägerfolie kann insbesondere derart erfolgen, dass die Trägerfolie an all denjenigen Stellen simultan von der Kleberschicht gelöst wird, die auf einer fix zur Abziehrichtung verlaufenden (insbesondere orthogonal zur Abziehrichtung verlaufenden) Gerade liegen. Beispielsweise löst sich ein auf einer Lasche aufliegender Bereich der Trägerfolie an all denjenigen Stellen simultan von der jeweiligen Lasche, die auf einer fix zu der Abziehrichtung verlaufenden (insbesondere orthogonal zur Abziehrichtung verlaufenden) Gerade liegen.

Beispielsweise weisen die Laschen ausschließlich oder zumindest überwiegend Außenkanten auf, die jeweils eine der folgenden Bedingungen erfüllen: (i) die betreffende Außenkante verläuft parallel zu der Abziehrichtung; (ii) die betreffende Außenkante verläuft in einem stumpfen Winkel zur Abziehrichtung; (iii) die betreffende Außenkante verläuft gekrümmt, z.B. kurvenförmig oder geschwungen, wobei Tangenten der Außenkante parallel oder in einem spitzen Winkel zur Abziehrichtung verlaufen.

Eine erfindungsgemäße Lasche bzw. jede Lasche der erfindungsgemäßen Kleberschicht kann mindestens ein Paar, beispielsweise drei oder fünf Paare, von aneinander angrenzenden Außenkanten umfassen, wobei die Außenkanten des mindestens einen Paars relativ zueinander schräg verlaufen, wobei eine zwischen den Außenkanten des mindestens einen Paars liegende Ecke beispielsweise verrundet ist. Die Lasche umfasst beispielsweise ausschließlich verrundete Ecken, also keine spitzen oder unverrundeten Ecken.

Durch diese Ausgestaltungen kann ein vollständiges bzw. rückstandsfreies Abziehen der Trägerfolie von der Kleberschicht sichergestellt werden. Auch kann einem Einreißen der Trägerfolie und/oder der Kleberschicht vorgebeugt werden. Ferner wird die Gefahr eines Ablösens der Kleberschicht von dem Modulträgerband bzw. den Chipmodulen minimiert bzw. wenigstens deutlich verringert.

Die Laschen können spiegelsymmetrisch ausgebildet werden. Die Laschen können V-förmig oder U-förmig ausgebildet werden. Die Laschen können jeweils zwei parallel verlaufende Außenkanten umfassen. Die Laschen können jeweils in unterschiedlichen Formen ausgebildet werden, zum Beispiel in Form von Dreiecken, Rechtecken, Trapezen oder Rechtecken mit jeweils aufgesetzten Dreiecken. Hierbei stellt der jeweils an einer der Laschen angrenzende Abschnitt der Kleberschicht eine Seite der betreffenden geometrischen Form dar. Die Laschen können so ausgebildet werden, dass ihre Breiten jeweils in Richtung eines distalen Endes der jeweiligen Lasche abnehmen, z.B. monoton oder streng monoton. Die Breiten der Laschen können jeweils in Richtung des distalen Endes der betreffenden Lasche stetig abnehmen. Die Breiten der Laschen können insbesondere von dem jeweils an die Laschen angrenzenden Abschnitten der Kleberschicht zu einem jeweils von diesem Abschnitt beabstandeten, insbesondere entferntesten Bereich der Laschen (z.B. dem distalen Ende) abnehmen. Die Laschen können in Richtung des betreffenden distalen Endes zulaufen.

Derartige Formen der Laschen haben sich als vorteilhaft für die Lösung der oben genannten Aufgabe erwiesen. Auch maximieren derartige Formen der Laschen das Abziehen der Trägerfolie bzw. vereinfachen es signifikant.

Gemäß der vorliegenden Erfindung können die Laschen ausbildenden Aussparungen oder Schnittmuster durch ein Schneidverfahren (z.B. mittels eines Messers, eines Lasers oder eines Flüssigkeitsstrahls) oder durch ein Stanzverfahren (z.B. mittels eines Stanzwerkzeugs) in die Kleberschicht eingebracht werden. Selbiges trifft auch auf das Ausbilden der Kontaktaussparungen und weiteren in der Kleberschicht auszubildenden Aussparungen oder Öffnung zu.

Es versteht sich, dass beim Schneiden oder Stanzen der Kleberschicht auch die Trägerfolie geschnitten oder gestanzt werden kann. So können auch in die Trägerfolie Laschen eingeschnitten oder eingestanzt werden, die den Laschen der Kleberfolie entsprechen. Ebenso ist möglich, in der Trägerfolie Aussparungen und/oder Schnittmuster auszubilden, die den Aussparungen und/oder Schnittmustern der Kleberfolie entsprechen.

Bei dem Verbinden der Kleberschicht mit dem Modulträgerband werden die Laschen beispielsweise auf die Oberfläche des Chipmoduls bzw. einer Vergußmasse des Chipmoduls aufgedrückt, aufgepresst oder aufgeklebt. Gemäß einem Beispiel werden gleichzeitig mit den betreffenden Laschen auch die Laschen jeweils angrenzenden Abschnitte der Kleberschicht auf die Oberfläche der umliegenden Basisbereiche des Modulträgerbands aufgedrückt, aufgepresst oder aufgeklebt. Ebenso werden diejenigen Abschnitte der Kleberfolie, die auf den Flanken der Chipmodule zu liegen kommen, auf diese aufgedrückt oder aufgepresst. Hierbei können die Laschen mit einem geringeren Druck aufgedrückt werden als die an die Laschen angrenzenden Abschnitte der Kleberschicht.

Zum Aufdrücken oder Aufpressen der Laschen kann ein flexibler Stempel, insbesondere ein Stempel aus einem elastischen, wärmeleitfähigen Material verwendet werden. Der Stempel kann aus einem geeigneten Polymer gefertigt sein, beispielsweise aus Silikon. Der Stempel kann ein Teil eines beheizten Fixierwerkzeugs sein. Das Fixierwerkzeug kann in den Stempel umgebenden Bereichen eine oder mehrere Fixierstrukturen umfassen, die die Kleberschicht, insbesondere den an die Lasche angrenzenden Abschnitt der Kleberschicht oder/und die weiteren Bereiche oder Abschnitte der Kleberschicht auf das Modulträgerband, insbesondere auf die Chipmodule und deren Flanken, aufdrücken, während der flexible Stempel in einem oder einer Reihe von aufeinanderfolgenden Arbeitsschritten die Laschen auf die jeweiligen Chipmodule aufdrückt. Die Fixierstrukturen können aus einem härteren Material bestehen als der flexible Stempel, zum Beispiel aus Metall oder Hartgummi.

Hierdurch wird einer Beschädigung der Chipmodule vorgebeugt und es wird eine sichere Befestigung der Kleberschicht erreicht.

Bei dem Verfahren können das Modulträgerband und die Kleberschicht in dieselbe Transportrichtung bewegt werden (z.B. relativ zu dem Stempel oder dem Fixierwerkzeug), und zwar insbesondere mit derselben Geschwindigkeit oder/und mit derselben Schrittgröße. Die Kleberschicht kann beispielsweise mittels Lamination mit dem Modulträgerband und den Chipmodulen verbunden werden.

Gemäß einem zweiten Aspekt der vorliegenden Erfindung wird eine Vorrichtung zum Aufbringen einer Kleberschicht auf ein mit einer Vielzahl von Chipmodulen versehenes Modulträgerband bereitgestellt. Die Vorrichtung umfasst eine Bearbeitungseinheit, die eingerichtet ist, in einer Kleberschicht Laschen derart auszubilden, dass die Laschen mit den Chipmodulen des Modulträgerbands korrespondieren, mit welchem die Kleberschicht anschließend verbunden werden soll. Die Bearbeitungseinheit kann ein Messer, einen Laser oder/und eine Flüssigkeitsstrahlvorrichtung umfassen. Die Bearbeitungseinheit kann alternativ oder zusätzlich eine Stanzwerkzeug umfassen. Die erfindungsgemäße Vorrichtung umfasst ferner eine Verbindungseinheit, die eingerichtet ist, die Kleberschicht derart mit dem Modulträgerband zu verbinden, dass die Laschen auf den Oberflächen der Chipmodule aufliegen und an die Laschen angrenzende Abschnitte der Kleberschicht auf den Basisbereichen des Modulträgerbands aufliegen. Die Verbindungseinheit kann zum Wärmetransfer der Kleberschicht eingerichtet sein. Die Verbindungseinheit kann den im Zusammenhang mit dem ersten Aspekt beschriebenen flexiblen, wärmeleitenden Stempel und/oder das Fixierwerkzeug umfassen. Insbesondere die Bearbeitungseinheit kann auch in einer separaten Vorrichtung verwirklicht sein, die von derjenigen Vorrichtung baulich getrennt ist, welche die Verbindungeinheit umfasst.

Die Vorrichtung ist dazu eingerichtet, das Verfahren gemäß dem ersten Aspekt auszuführen. Hierzu kann die Vorrichtung eine Abziehvorrichtung umfassen, die zum Abziehen der Trägerfolie eingerichtet ist. Die Bearbeitungseinheit kann ferner dazu eingerichtet sein, die Aussparungen bzw. Schnittmuster sowie die Kontaktaussparungen auszubilden. Die Vorrichtung kann dazu eingerichtet sein, das Modulträgerband in eine Transportrichtung zu bewegen (z.B. relativ zu der Bearbeitungseinheit oder der Verbindungseinheit) und die Kleberschicht in derselben Transportrichtung zu bewegen, insbesondere in derselben Geschwindigkeit oder/und mit derselben Schrittgröße. Die Vorrichtung kann dazu eingerichtet sein, die Kleberschicht mittels Lamination mit dem Modulträgerband und den Chipmodulen zu verbinden. Das Aufbringen der Kleberschicht auf die einzelnen oder Gruppen von Chipmodulen im Rahmen des Verbindens der Kleberschicht mit dem Modulträgerband schreitet vorzugsweise mit der in derselben Geschwindigkeit oder/und mit derselben Schrittgröße voran, mit der das Modulträgerband in Transportrichtung bewegt wird.

Gemäß einem dritten Aspekt der Erfindung wird ein mit einer Kleberschicht verbundenes Modulträgerband bereitgestellt, welches mit einer Vielzahl von Chipmodulen versehen ist. Die Kleberschicht umfasst Laschen, die mit den Chipmodulen des Modulträgerbands korrespondieren, und ist derart mit dem Modulträgerband verbunden, dass die Laschen auf den Oberflächen der Chipmodule aufliegen und an die Laschen angrenzende Abschnitte der Kleberschicht auf den Basisbereichen des Modulträgerbands aufliegen. Die Kleberschicht liegt außerdem auf den Flanken der Chipmodule auf, denn die darin vorgesehenen Schnittmuster und/oder Aussparungen erlauben das falten- und streckungsfreie Bedecken des Gesamtfläche des Modulträgerbands einschließlich aller Chipmodule durch die Kleberschicht.

Gemäß einem vierten Aspekt der vorliegenden Erfindung wird eine Kleberschicht zum Verbinden mit einem Modulträgerband bereitgestellt. Die Kleberschicht umfasst Laschen, die von umliegenden Bereichen der Kleberschicht getrennt sind und insofern unabhängig von der restlichen Kleberschicht bewegbar sein können. Die Kleberschicht ist dazu ausgebildet, mit dem flächig ausgebildeten Modulträgerband verbunden zu werden, wobei auf dem Modulträgerband Chipmodule angeordnet sind, deren Oberflächen gegenüber den Basisbereichen des Modulträgerbands erhöht sind. Die Laschen sind so ausgebildet, dass sie jeweils mit den Chipmodulen korrespondieren und auf deren Oberflächen befestigt werden können. An die Laschen angrenzende Abschnitte der Kleberschicht können auf den umliegenden Basisbereichen des Modulträgerbands befestigt werden.

Die Kleberschicht kann der zum ersten Aspekt beschriebenen Kleberschicht nach dem Schritt des Ausbildens der Laschen entsprechen. Die Kleberschicht kann durch die Vorrichtung gemäß dem zweiten Aspekt hergestellt werden, indem die Vorrichtung die Laschen ausbildet. Die Kleberschicht kann derjenigen gemäß dem ersten Aspekt nach dem Schritt des Ausbildens der Schnittmuster und/oder Aussparungen und/oder Kontaktaussparungen entsprechen. Die Kleberschicht kann, wie zum ersten Aspekt erläutert, auf einer Trägerfolie angeordnet oder/und eine Heißkleberschicht sein.

Gemäß einem fünften Aspekt der vorliegenden Erfindung wird ein Verfahren zum Herstellen eines portablen Datenträgers bereitgestellt, welcher ein Chipmodul umfasst. In Rahmen dieses Verfahrens wird zunächst ein Datenträgerkörper bereitgestellt, der elektrische Strukturen mit Kontakten umfasst, welche über eine Kavität des Datenträgerkörpers kontaktierbar sind. Die Kavität ist hierbei vorgesehen und derart ausgestaltet, dass sie das Chipmodul vorzugsweise passgenau aufnimmt. Gemäß einem weiteren Schritt wird ein mit einer Kleberschicht versehenes Modulträgerband gemäß dem dritten Aspekt bereitgestellt und das in die Kavität einzusetzende Chipmodul mitsamt der verbundenen Kleberschicht mit geeigneten Schneid- oder Trennmitteln vereinzelt, so dass das betreffende Chipmodul einerseits mit dem korrespondierenden Kleberschichtabschnitt versehen ist und andererseits von den weiteren Chipmodulen des Modulträgerbandes isoliert ist. Schließlich wird das vereinzelte Chipmodul in die Kavität des Datenträgerkörpers derart eingesetzt, dass die der betreffende Kleberschichtabschnitt das Chipmodul fest in der Kavität fixiert und/oder das Chipmodul die Kontakte der elektrischen Strukturen kontaktiert.

Es versteht sich, dass die obigen Ausführungen zum ersten Aspekt entsprechend für den zweiten, dritten, vierten und fünften Aspekt gelten. Auch die Definitionen aus dem einleitenden Teil der Beschreibung sind auf alle beschriebenen Aspekte der Erfindung anwendbar, und einzelne oder sämtliche der im einleitenden Teil der Beschreibung beschriebenen Merkmale können ebenso in den Ausführungsformen gemäß allen Aspekten der Erfindung vorgesehen sein.

Im Folgenden wird die vorliegende Erfindung mit Bezug auf die beiliegenden Zeichnungen beispielhaft beschrieben, wobei dieselben Bezugszeichen dieselben strukturellen oder/und funktionellen Merkmale angeben. Es zeigen:
- Fig. 1: eine schematische Darstellung eines beispielhaften Sicherheitsdokuments;
- Fig. 2: eine schematische Darstellung eines Ausschnitts eines Modulträgerbandes, das mit einem Chipmodul mit einer herkömmlichen Kleberschicht versehen ist;
- Fig. 3A: eine schematische Darstellung eines Modulträgerbands mit einer Vielzahl von Chipmodulen und einer darauf aufgebrachten herkömmlichen Kleberschicht;
- Fig. 3B: eine dimensionskorrekte Gegenüberstellung eines Abschnitts der Kleberschicht nach Fig. 3A und des Chipmoduls nach Fig. 2;
- Fig. 4A-4D: eine bevorzugte Ausführungsform eines Schnittmusters und einer Kleberschicht;
- Fig. 5A-5B: eine bevorzugte Ausführungsform einer Kleberschicht;
- Fig. 6A-6B: eine bevorzugte Ausführungsform eines Schnittmusters und einer Kleberschicht;
- Fig. 7A-7B: eine bevorzugte Ausführungsform eines Schnittmusters und einer Kleberschicht;
- Fig. 8A-8B: eine bevorzugte Ausführungsform eines Schnittmusters und einer Kleberschicht;
- Fig. 9A-9B: eine bevorzugte Ausführungsform eines Schnittmusters und einer Kleberschicht;
- Fig. 10A-10B: eine bevorzugte Ausführungsform eines Schnittmusters und einer Kleberschicht;
- Fig. 11A-11B: eine bevorzugte Ausführungsform eines Schnittmusters und einer Kleberschicht;
- Fig. 12A-12B: eine bevorzugte Ausführungsform eines Schnittmusters und einer Kleberschicht;
- Fig. 13: eine bevorzugte Ausführungsform eines Fixierwerkzeugs; und
- Fig. 14: eine bevorzugte Ausführungsform eines Verfahrens.

Fig. 1 zeigt ein Beispiel eines portablen Datenträgers in Form eines Sicherheitsdokuments 2. Das Sicherheitsdokument 2 ist in diesem Fall eine Sicherheitskarte, z.B. eine Kreditkarte, eine Schlüsselkarte oder eine Identifizierungskarte, etwa ein Personalausweis. Auch andere Arten von Sicherheitsdokumenten sind denkbar, insbesondere Sicherheitsdokumente in Blattform wie z.B. Banknoten, Gutscheine oder dergleichen.

Das Sicherheitsdokument 2 kann ein Bild 4 umfassen, beispielsweise ein Passbild des Inhabers. Ferner kann das Sicherheitsdokument 2 Schrift- und Zahleninformationen 6 umfassen, z.B. einen Namen, eine Postanschrift oder/und eine Benutzerkennung des Inhabers oder Informationen betreffend den Herausgeber des Sicherheitsdokuments.

Das Sicherheitsdokument 2 umfasst ein dreidimensional strukturiertes Chipmodul 8 mit einem (Mikro-) Chip 10 und/oder weiteren elektronischen Bauteilen, etwa integrierte Schaltkreise (ICs), Mikroprozessoren, elektronischen Speichern oder dergleichen. Das Chipmodul 8 kann auch einen Sensor oder weiter Chips umfassen Beispielsweise sind in dem Chip 10 Informationen speicherbar oder gespeichert, insbesondere zum Inhaber oder Herausgeber des Sicherheitsdokuments 2. Das Sicherheitsdokument 2 kann auch einen Sensor oder eine Mehrzahl an Sensoren umfassen, die mit dem Chip 10 verbunden sind. Bei dem Sensor kann es sich um einen Fingerabdrucksensor oder einen optischen Scanner handeln. Der Chip 10 kann in diesem Fall einen Prozessor umfassen, der Daten des Sensors oder der Mehrzahl an Sensoren verarbeitet und ein Verarbeitungsresultat ausgibt, beispielsweise an eine Ausgabeeinheit (z.B. eine Leuchtdiode oder ein Display) des Sicherheitsdokuments 2 oder an eine externe Einheit, z.B. eine Identitätsüberprüfungseinheit (z.B. mittels einer drahtlosen Kommunikationsverbindung oder Broadcasting). Gemäß alternativer Ausführungsformen kann der Chip 10 selbst auch als Sensor ausgebildet sein, während das Sicherheitsdokument 2 weitere Chips und/oder Sicherheitselemente aufweist.

Fig. 2 zeigt einen Querschnitt durch das Chipmodul 8 und dessen Chip 10 während eines Herstellungsschritts zur Herstellung des Sicherheitsdokuments 2.

Es ist zu erkennen, dass das Chipmodul 8 auf einem flächigen Modulträgerband 12 angeordnet ist. Das Chipmodul 8 weist eine Oberfläche 14 auf, die aufgrund bzw. im Bereich des Chips 10 gegenüber einer Oberfläche 16 des Modulträgerbands 12 erhöht ist. Bei der Oberfläche 16 handelt es sich um die Oberfläche eines an das Chipmodule 8 angrenzenden Basisbereichs 18 des Modulträgerbands 12. Das Chipmodul 8 umfasst den Chip 10, an welchem Bonddrähte 22 angeschlossen sind. Der Chip 10 und die Bonddrähte 22 können von einer Einkapselung bzw. Schutzschicht 24 eingekapselt sein. Bei der Schutzschicht 24 kann es sich beispielsweise um ein gehärtetes Epoxidharz oder eine andere geeignete Vergußmasse handeln, die die Oberfläche 14 des Chipmoduls 8 bildet. Auf dem Modulträgerband 12 sind elektrische Kontaktelemente 26 angeordnet, die jeweils mit einem oder mehreren der Bonddrähte 22 verbunden sein können.

Um das Chipmodul 8 später fest in einen geeigneten Datenträgerkörper einsetzen zu können und dadurch ein Sicherheitsdokument 2 gemäß Fig. 1 zu bilden, ist zur späteren Haftvermittlung zwischen dem Chipmodul 8 und dem Datenträgerkörper eine Kleberschicht 28 auf das Modulträgerband 12 und das Chipmodul 8 aufgebracht. Beispielsweise handelt es sich bei dieser Kleberschicht 28 um eine als Transferschicht ausgebildete Heißkleberschicht, die wie in Fig. 2 dargestellt auf einer Trägerfolie 30 vorgehalten ist. Gemäß diesem Beispiel handelt es sich bei der Kleberschicht 28 sowie bei der Trägerfolie 30 um jeweils durchgehende Schichten bzw. Folien, in die jeweils übereinanderliegende Aussparungen bzw. Kontaktaussparungen 32 eingebracht sind. Die Kontaktaussparungen 32 können beim Verbinden der Kleberschicht 28 mit dem Modulträgerband 12 und mit dem Chipmodul 8 so angeordnet werden, dass die Kontaktaussparungen 32 über den elektrischen Kontaktelementen 26 liegen. Auf diese Weise wird sichergestellt, dass kein Teil der Kleberschicht 28 auf den elektrischen Kontaktelementen 26 angeordnet wird, letztere also frei bleiben und beim späteren Einbringen in einen Datenträgerkörper kontaktierbar sind. Zum Verbinden der Kleberschicht 28 mit dem Modulträgerband 12 können Abschnitte der Trägerfolie 30 und der Kleberschicht 28 auf das Modulträgerband 12 aufgedrückt werden, insbesondere auf die Oberfläche 14 und die Oberfläche 16 der umliegenden Basisbereiche 18.

Wie in Fig. 2 gezeigt ist, muss von der Kleberschicht 28 und von der Trägerfolie 30 eine größere Fläche überspannt werden als von dem Modulträgerband 12, denn die Kleberschicht 28 und die Trägerfolie 30 verlaufen aufgrund des erhöhten Chipmoduls 8 bzw. dessen Vergußmasse 24 nicht durchgehend parallel zu dem Modulträgerband 12. Durch die erhöhte Form des dreidimensional strukturierten Chipmoduls 8 gegenüber der Oberfläche 16 wird also eine größere Fläche an Kleberschicht 28 benötigt im Vergleich zu der entsprechend überspannenden Grundfläche des Modulträgerbands 12.

Bei bekannten Verfahren zum Aufbringen der Kleberschicht 28 auf das Modulträgerband 12 wird üblicherweise dieselbe Fläche an Kleberschicht 28 verwendet wie die zu überspannende Grundfläche des Modulträgerbands 12. Die erhöhte, dreidimensionale Struktur des Chipmodules 8 bleibt herkömmlich unberücksichtigt. Beim Verbinden der Kleberschicht 28 mit dem Modulträgerband 12 und mit dem erhöhten Chipmodul 8 kann es folglich zu deutlichem Versatz zwischen der Kleberschicht 28 und dem Modulträgerband 12 kommen, was insbesondere dazu führt, dass die Klebefolie 28 relativ zu dem Chipmodul 8 oder/und den elektrischen Kontaktelementen 26 falsch positioniert ist. Dieses nachteilige Phänomen ist in Fig. 3 schematisch dargestellt.

In der bereits eingangs angesprochenen Fig. 3 ist die Kleberschicht 28 als Bahnmaterial dargestellt. Die Kleberschicht 28 ist auf der Trägerfolie 30 angeordnet und kann auf einer Rolle vorgehalten werden. In die Kleberschicht 28 und die Trägerfolie 30 sind Kontaktaussparungen 32 eingebracht. Außerdem sind in die Kleberschicht 28 und die Trägerfolie 30 Aussparungen 36 eingebracht. Die Kontaktaussparungen 32 sollen über den elektrischen Kontaktelementen 26 und die Aussparungen 36 mittig über dem Chipmodulen 8 auf der Oberfläche 14 positioniert werden.

Die einzelnen Chipmodule 8 sind auf einem durchgehenden Modulträgerband 12 angeordnet. Die Chipmodule 8 können nach dem Aufbringen der Kleberschicht 28 vereinzelt werden. Jedes der Chipmodule 8 kann zur Herstellung eines portablen Datenträgers, etwa des Sicherheitsdokuments 2 verwendet werden, beispielsweise durch Einsetzen, Einlaminieren oder Befestigen an/in einem Teil des Sicherheitsdokuments 12, etwa in einer geeigneten Kavität.

Beginnend mit dem in Fig. 3 links gezeigten Ende werden die Kleberschicht 28 und die Trägerfolie 30 auf ein Modulträgerband 12 mit einer Vielzahl von regelmäßig beabstandeten Chipmodulen 8 aufgebracht. Es ist zu erkennen, dass es durch den erhöhten Bedarf an Kleberschicht 28 zum Bedecken der erhöhten Chipmodule 8 entlang der Längsrichtung der Kleberschicht 28 zu einem fortschreitenden Versatz zwischen den Kontaktaussparungen 32 und Aussparungen 36 einerseits und den Kontaktelementen 26 und Chipmodulen 8 andererseits kommt. Zwar ist der durch ein einzelnes Chipmodul 8 entstehende Versatz gering, jedoch summiert sich der Versatz entlang der Aufbringungsrichtung (also in Fig. 3 nach rechts hin) im Laufe der Zeit so auf, dass die Chipmodule 8 sogar unbrauchbar werden, da die Fehlausrichtung zwischen der Kleberschicht 28 und dem Modulträgerband 12 bzw. dessen Chipmodulen 8 Produktionsfehler bilden. Beispielsweise könnten infolge des Versatzes die elektrischen Kontaktelemente 26 teilweise oder komplett von der Kleberschicht 28 bedeckt werden, und/oder die Aussparung 36 könnte teilweise oder komplett außerhalb oder neben der Oberfläche 14 platziert werden.

Gemäß der vorliegenden Erfindung wird eine Kleberschicht 28 bereitgestellt, die mit einem Modulträgerband 12 verbunden werden soll und die dazu Laschen 38 umfasst, welche mit den Chipmodulen 8 des Modulträgerbands 12 korrespondieren. Insbesondere ist vorgesehen, dass die Laschen 38 durch Trennen der Laschen 38 von den umliegenden Bereichen der Kleberschicht 28 ausgebildet werden, etwa aufgrund von geeignet in die Kleberschicht 28 eingebrachte Schnittmuster und/oder Aussparungen 32, 36. Die Laschen 38 können ebenso wie die Kontaktaussparungen 32 oder/und die Aussparungen 36 sowie weitere Aussparungen auf verschiedene Weisen erzeugt werden. So können beispielsweise Stanzverfahren oder Schneidverfahren eingesetzt werden. Wenn im Folgenden auf ein Stanzmuster oder ein Schnittmuster abgestellt wird, ist darunter ein Muster zu verstehen, welches durch Stanzen oder Schneiden in die Kleberschicht 28 eingebracht werden kann, oder welches bei der Produktion der Kleberschicht 28 freigelassen wird. Die Begriffe Schnittmuster und Stanzmuster, Schnittmusterabschnitt und Stanzmusterabschnitt, Schnittkante und Stanzkante usw. werden jeweils Synonym verwendet und sollen sowohl das Einschneiden als auch das Ausstanzen umfassen.

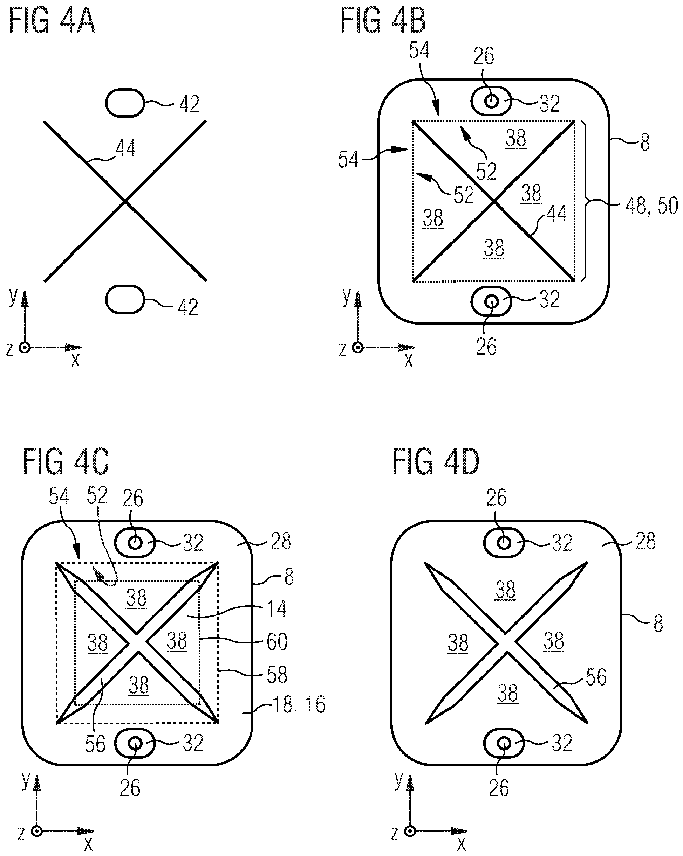

Die im Weiteren beschriebenen Figuren 4 und 6 bis 12 zeigen jeweils einzelne Abschnitte einer großflächigeren Kleberfolie 28, die jeweils vorgesehen sind, ein einzelnes Chipmodul 8 mit Kontakten 26 eines großflächigeren Modulträgerbands 12 zu bedecken. Sämtliche diesbezügliche Ausführungsbeispiele sind also so zu verstehen, dass sie einen illustrativen Ausschnitt eines mit einer Kleberfolie 28 bedeckten Modulträgerbands 12 zeigen, dass eine Vielzahl von Chipmodulen 8 umfasst.

In Fig. 4A ist ein Stanz- bzw. Schnittmuster gemäß einer bevorzugten Ausführungsform dargestellt. Dieses Stanzmuster wird in die Kleberschicht 28 eingebracht, um die Laschen 38 auszubilden. Selbstverständlich kann simultan auch die Trägerfolie 30 von demselben Schnittmuster durchbrochen werden. In Fig. 4A ist einerseits ein kreuzförmiges Stanz- bzw. Schnittmuster 44 eingebracht, das einen entsprechenden kreuzförmigen Durchbruch zur Folge hat, durch den vier Laschen 38 ausgebildet werden. Andererseits werden durch in sich geschlossene Stanz- bzw. Schnittlinien 42 zwei Kontaktaussparungen 32 in der Kleberschicht 28 ausgebildet, die in Fig. 4B dargestellt sind. Die Kontaktaussparungen 32 sind beispielsweise kreisförmig, elliptisch oder verrundet.

In Fig. 4B ist eine Ansicht der Kleberschicht 28 dargestellt, welche mit dem Stanzmuster 44 aus Fig. 4A versehen wurde. Ferner ist ein Chipmodul 8 angedeutet, auf welchem die Kleberschicht 28 befestigt werden soll. Es ist zu erkennen, dass der kreuzförmige Durchbruch entlang des Stanzmusters 44 so dimensioniert ist, dass die Breite 48 der dreieckigen Laschen 38 jeweils der Breite 50 des erhöhten Bereichs (entsprechend der Oberfläche 14) des zu überdeckenden Chipmoduls 8 entspricht. Im dargestellten Beispiel liegen die Außenkanten des quaderförmigen erhöhten Bereichs zwischen Anschlussbereichen 52 der einzelnen Laschen 38 und Abschnitten 54 der Kleberschicht 28, wobei jeder der Anschlussbereiche 52 an jeweils einen Abschnitt 54 der Kleberschicht 28 angrenzt.

Bei dem Aufdrücken der Abschnitte 54 auf die Oberfläche 16 des Modulträgerbands 12 können die einzelnen Laschen 38 nach oben hin aufgeweitet bzw. aufgefaltet werden. Dies ist schematisch in Fig. 4C dargestellt. Durch das erhabene Chipmodul 8 werden die Laschen 38 derart nach oben aufgebogen, dass sich zwischen den einzelnen Laschen 38 ein Freiraum 56 bildet. In Fig. 4C sind beispielhaft Knicklinien 58 und 60 der Laschen 38 dargestellt. Die äußere Knicklinie 58 entspricht in diesem Beispiel einem Außenrand des Chipmoduls 8 auf Höhe der Oberfläche 16 der Basisbereiche 18 des Modulträgerbands 12. Die innere Knicklinie 60 entspricht einer Außenkante auf Höhe der Oberfläche 14.

Durch Aufdrücken der Laschen 38 auf die Oberfläche 14 können die einzelnen Laschen 38 auf der Oberfläche 14 der Struktur 8 befestigt werden. Die an die Laschen 38 angrenzenden Abschnitte 54 können auf dem Modulträgerband 12 befestigt werden. Letztlich erhält man also die in Fig. 4D dargestellte Ausgestaltung. Hierbei handelt es sich um eine Draufsicht auf die auf das Chipmodul 8 und das Modulträgerband 12 aufgebrachte Kleberschicht 28. Es ist zu erkennen, dass in diesem Beispiel nur die Laschen 38 im Bereich der Chipmodule 8 angeordnet sind. Durch den kreuzförmigen Durchbruch 56 der Kleberschicht 28, bzw. durch das Ausformen der einzelnen Laschen 38 in der Kleberschicht 28 kann sichergestellt werden, dass die Kleberschicht 28 beim Bedecken der Chipmodule 8 nicht gestreckt werden muss. Auch ein erhöhter Flächenverbrauch an Kleberschicht 28 durch das erhöhte Chipmodul 8 wird verhindert. Somit kann durch die Kleberschicht 28 gemäß den Figuren 4A bis 4D sichergestellt werden, dass der in Fig. 3 illustrierte Versatz verhindert oder zumindest weitgehend minimiert wird.

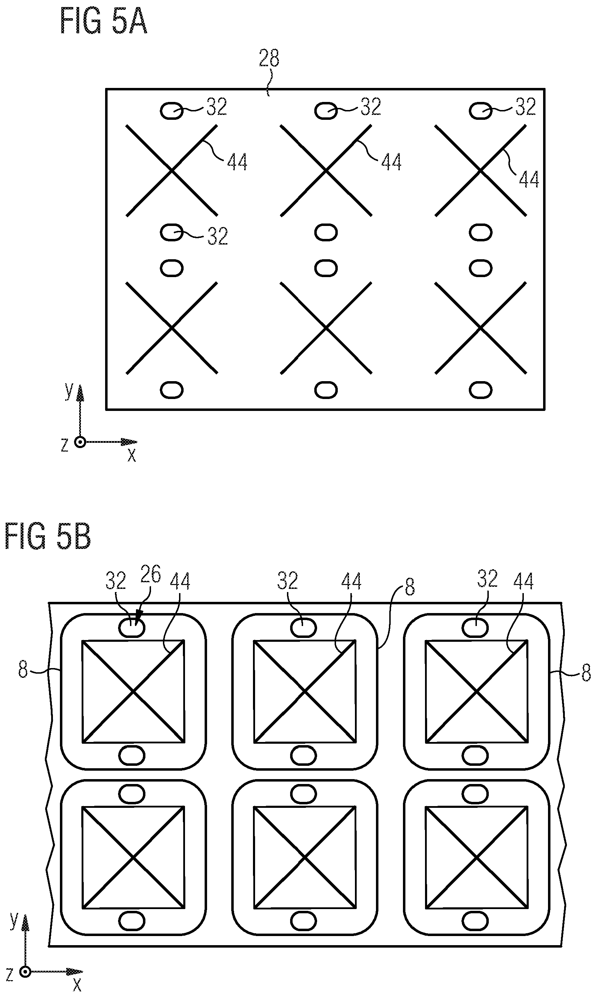

Fig. 5A zeigt ein Beispiel einer Kleberschicht 28 gemäß der vorliegenden Erfindung. In die Kleberschicht 28 wurde hierbei eine Mehrzahl der Schnitt- bzw. Stanzmuster 44 gemäß Fig. 4A eingebracht. Die Kleberschicht 28 umfasst eine Vielzahl von Laschen 38 und ist dazu eingerichtet, auf eine Vielzahl von Chipmodulen 8 aufgebracht zu werden. Die Kleberschicht 28 kann auf der Trägerfolie 30 vorgehalten werden oder angeordnet sein und kann insbesondere als Heißkleberschicht bzw. Hotmelt ausgebildet sein. Insbesondere kann die Kleberschicht 28 und die Trägerfolie 30 als Rollenmaterial ausgestaltet sein. In Fig. 5B ist die Anordnung der Kleberschicht 28 aus Fig. 5A auf einer Vielzahl von Chipmodulen 8 dargestellt. Es ist zu erkennen, dass die einzelnen Laschen 38 auf den betreffenden Chipmodulen 8 aufliegen, und dass der Versatz im Vergleich mit dem in Fig. 3 erläuterten Versatz betreffend eine herkömmliche Kleberschicht 28 vernachlässigbar ist.

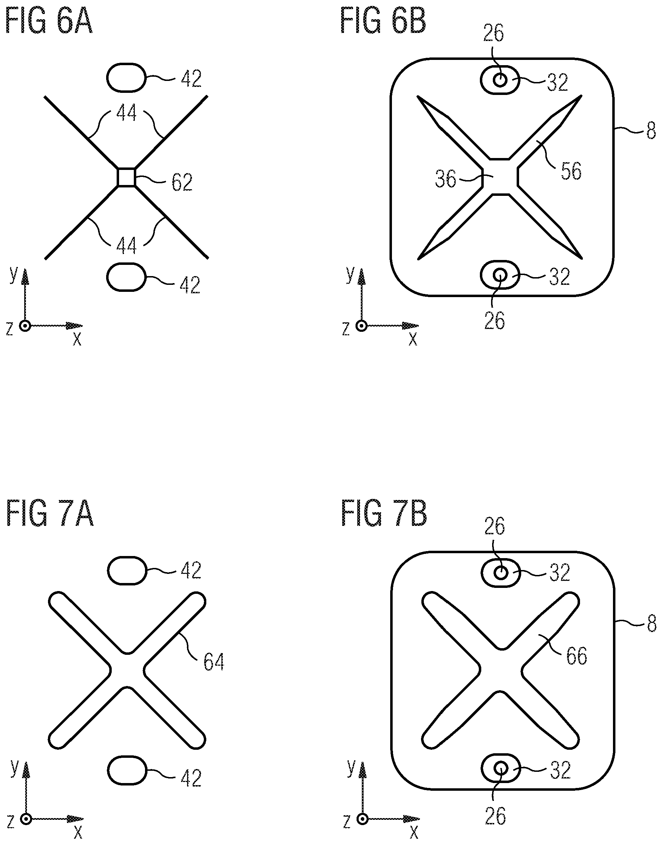

In Fig. 6A ist eine weitere bevorzugte Ausführungsform eines Stanz- bzw. Schnittmusters 44 zum Einbringen in die Kleberschicht 28 dargestellt. Im Vergleich zur Fig. 4A ist zu erkennen, dass zusätzlich zu dem kreuzförmigen Schnittmuster 44 in der Mitte des Kreuzschnitts eine in sich geschlossene Schnittlinie 62 vorgesehen ist. Die Schnittlinie 62 kann dazu dienen, in der Kleberschicht 28 eine Aussparung 36 einzubringen, die auf dem Chipmodul 8 angeordnet wird. Die Form der mit dem Schnittmuster 44 gemäß Fig. 6A versehenen Kleberschicht 28 nach dem Aufbringen auf ein Chipmodul 8 des Modulträgerbands 12 ist in Fig. 6B dargestellt. Es ist zu erkennen, dass die Aussparung 36 mittig auf der Oberfläche 14 des Chipmoduls 8 angeordnet ist. Auch entsteht durch das Aufklappen der einzelnen Laschen 38 nach oben (also in Fig. 6B in Richtung des Betrachters) der Freiraum 56, wie im Fall von Fig. 4E und 4D. Das Vorsehen der Aussparung 36 und/oder des Freiraums 56 verhindert bzw. minimiert Streckungen oder Spannungen in der Kleberschicht 28.

In Fig. 7A ist ein weiteres mögliches Schnitt- bzw. Stanzmuster dargestellt, welches in die Kleberschicht 28 und in die Trägerfolie 30 eingebracht ist. Hierbei umfasst das Stanzmuster einen in sich geschlossenen kreuzförmigen Stanzmusterabschnitt 64. Der Stanzmusterabschnitt 64 bewirkt beim Stanzen in die Kleberschicht 28 das Ausbilden der Laschen 38. Der Stanzmusterabschnitt 64 ist im Gegensatz zum Stanzmusterabschnitt 44 flächig ausgestaltet. Der Stanzmusterabschnitt 64 bewirkt beim Einbringen in die Kleberschicht 28 das Bilden einer zusätzlichen Aussparung, welche an sämtliche Außenkanten der einzelnen Laschen 38 angrenzt. Die Laschen 38 werden also durch das Einbringen der zusätzlichen Aussparung gebildet. In Fig. 7B ist die Anordnung der Kleberschicht 28 gemäß Fig. 7A auf einem Chipmodule 8 eines Modulträgerbands 12 dargestellt. Die Form der Laschen 38 gemäß den Fig. 4A bis 7B kann als V-förmig bezeichnet werden.

Der durch das Einbringen des Schnittmusterabschnitts 64 und das Auffalten der Laschen 38 entstehende Freiraum 66 in der Kleberschicht 12 ist im Vergleich zu den Ausgestaltungen gemäß Fig. 4D und Fig. 6B breiter, sodass Spannungen innerhalb der Kleberschicht 28 bzw. ein Versatz der Kleberschicht 28 in Bezug auf die Chipmodule 8 und das Substrat 12 weiter minimiert werden können, während gleichzeitig eine ausreichende und gleichmäßige Bedeckung der Struktur 8 mit der Kleberschicht 28 sichergestellt werden kann. Auch kann das Vorsehen eines flächig ausgebildeten Stanzmusterabschnitts 64 den Einsatz eines einfachen und kostengünstigen Stanzwerkzeugs ermöglichen.

Die Trägerfolie 30 kann von der Kleberschicht 28 nach dem Verbinden der Kleberschicht 28 mit dem Modulträgerband 12 und dessen Chipmodulen 8 abgezogen werden. Hierbei ist sicherzustellen, dass die gesamte Trägerfolie 30 von der Kleberschicht 28 entfernt wird. Mit anderen Worten sollten nach dem Abziehen der Trägerfolie 30 keine Rückstände auf der Kleberschicht 28 verbleiben. Experimentelle Versuche haben ergeben, dass bestimmte Umrisse und Formen der Laschen 38 ein zuverlässiges Abziehen der Trägerfolie 30 ermöglichen, während gleichzeitig die oben genannten erfindungsgemäßen Vorteile bestehen bleiben.

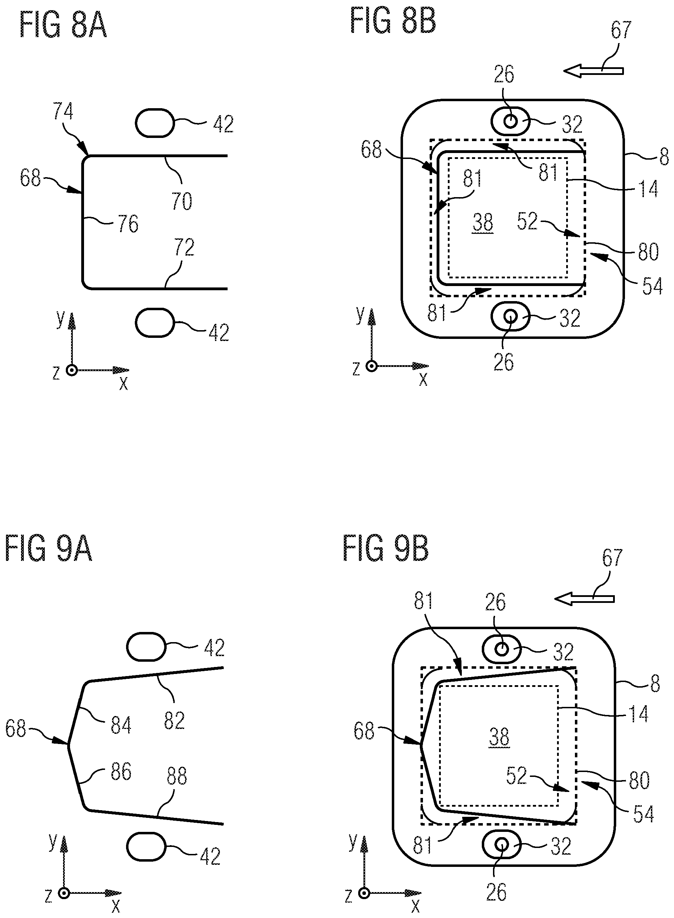

Im Zusammenhang mit den Ausführungsformen gemäß der Figuren 8A bis 12B wird deutlich, dass die Trägerfolie 30 beginnend mit einem in einer Abziehrichtung 67 hinten liegenden Abschnitt des Modulträgerbands 12 (bzw. der Kleberschicht 28) in Richtung eines in der Abziehrichtung 67 vorne liegenden Abschnitts des Modulträgerbands 12 (bzw. der Kleberschicht 28) abgezogen werden kann, wobei eine befestigte Lasche 38 mit ihrem distalen Ende 68 in eine vorbestimmte Richtung weist. Diese vorbestimmte Richtung kann orthogonal zur Abziehrichtung 67 verlaufen. Die vorbestimmte Richtung kann gegenüber der Abziehrichtung 67 alternativ in einem spitzen Winkel von dem hinten liegenden Abschnitt zu dem vorne liegenden Abschnitt verlaufen. Die vorbestimmte Richtung kann der Abziehrichtung 67 im Wesentlichen entsprechen. Alternativ oder zusätzlich kann eine Lasche 38 (z.B. nur) Außenkanten aufweisen, die jeweils (i) parallel zu der Abziehrichtung 67 verlaufen, die (ii) gegenüber der Abziehrichtung 67 in einem spitzen Winkel verlaufen, oder die (iii) gekrümmt verlaufen. Im Fall (iii) verläuft jede einzelne Tangente der Außenkante parallel zu der Abziehrichtung 67 oder verläuft gegenüber der Abziehrichtung 67 in einem spitzen Winkel.

Konkret zeigt Fig. 8A eine bevorzugte Ausführungsform eines Schnitt- bzw. Stanzmusters 74 mit Schnittkanten 70, 72, 76. Hierbei wird durch das Stanzmuster 74 eine einzelne Lasche 38 ausgebildet, welche auf einem Chipmodul 8 bzw. auf dessen Oberfläche 14 aufliegt bzw. befestigt werden kann. Die durch das Stanzmuster nach Fig. 8A in die Kleberschicht 28 eingebrachte Lasche 38 (siehe Fig. 8B) ist so geformt, dass beim Abziehen der Trägerfolie 30 in Abziehrichtung 67 zuerst der an die Lasche 38 angrenzende Abschnitt 54 der Kleberschicht 28 von der Trägerfolie 30 befreit wird, und anschließend die Lasche 38 selbst von der Trägerschicht 30 befreit wird. Gemäß Fig. 8B wird die Trägerfolie 30 also von rechts nach links in Abziehrichtung 67 abgezogen. Die Lasche 38 weist mit ihrem distalen Ende 68 weg von dem Anschlussbereich 52, der sich an einem proximalen Ende der Lasche 38 befindet. Die Lasche 38 wird durch Trennen von um die Lasche 38 herumliegenden Bereichen 81 der Kleberschicht 28 ausgebildet, insbesondere durch Ausbilden einer Aussparung in Form einer Durchbrechung in der Kleberschicht 28.

Die zwei Schnittkanten 70, 72 des Schnittmusterabschnitts 74 nach Fig. 8A verlaufen parallel zu der Abziehrichtung 67. Dies bewirkt, dass die Lasche 38 eine konstante Breite aufweist und parallel zur Abziehrichtung 67 ausgerichtet ist. Eine weitere Schnittkante 76 verläuft orthogonal zu der Abziehrichtung 67. Hierdurch liegt eine Außenkante der Lasche 38, die von der Schnittkante 76 gebildet wird, an dem distalen Ende 68 der Lasche 38 und verläuft orthogonal zur Abziehrichtung 67. Die Form der Lasche 38 kann als U-förmig bezeichnet werden. In Fig. 8B sind die Oberfläche 14 sowie eine Außenkante 80 des Chipmoduls 8 bzw. dessen Schutzschicht 24 strichliniert dargestellt. Das Schnitt- bzw. Stanzmuster ist dort so dimensioniert, dass die davon ausgebildete Lasche 38 das Chipmodul 8 zumindest im Bereich der Oberfläche 14 bedeckt, nachdem die Kleberschicht 28 auf das Chipmodul 8 aufgebracht wird. Die Lasche 38 kann breiter oder/und länger als die Oberfläche 14 sein und insbesondere auch dessen Flanken bedecken.

In dem Beispiel gemäß Fig. 8A und 8B ist der Anschlussbereich 52 schmaler als das Chipmodul 8, denn die Breite der Lasche 38 ist im Anschlussbereich 52 geringer als die Breite der Außenkante 80 des Chipmoduls 8. Allerdings ist es auch möglich, dass der Anschlussbereich 52 eine Breite aufweist, die der Breite des Chipmoduls 8 an einer ersten Seite des Chipmoduls 8 entspricht, wobei die erste Seite im Vergleich mit anderen Seiten des Chipmoduls 8 dem Anschlussbereich 52 am nächsten liegt. Im Fall der Fig. 8B kann also der Anschlussbereich 52 eine Breite aufweisen, die der Länge der Außenkante 80 des Chipmoduls 8 entspricht. Nachfolgend werden weitere Ausführungsformen beschrieben, bei denen diese Merkmale verwirklicht sein können.

In Fig. 9A ist eine weitere bevorzugte Ausführungsform eines Schnitt- bzw. Stanzmusters mit Schnittkanten 82, 84, 86, 88 dargestellt. Die dadurch erhaltene Ausgestaltung zeigt Fig. 9B. Die Form der Lasche 38 kann jeweils als im Wesentlichen U-förmig bezeichnet werden. Wie im Fall der oben beschriebenen V-förmigen Laschen 38 nimmt die Breite der Lasche 38 gemäß Fig. 9B in Richtung des distalen Endes 68 hin ab. Im Vergleich zur Fig. 8A verlaufen hierbei alle Außenkanten der Lasche 38 in einem stumpfen Winkel zur Abziehrichtung 67. Die einzelnen Schnittkanten 82, 84, 86, 88 verlaufen relativ zueinander schräg. Zwischen jedem Paar benachbarter Schnittkanten 82, 84, 86, 88 ist ein stumpfer Winkel gebildet. Die Bereiche des Schnittmusters, an denen die stumpfen Winkel liegen, können verrundet sein. Auch in den weiteren hierin beschriebenen Ausführungsformen kann vorgesehen sein, dass ein Außenumriss der Lasche nur verrundete Ecken umfasst.

Im Fall der Fig. 9A weist die Lasche 38 mit ihrem distalen Ende 68 nach links hin, die Lasche 38 weist also auch hier in die Abziehrichtung 67. So kann sichergestellt werden, dass zuerst die Trägerschicht 30 von dem an die Lasche 38 angrenzenden Bereich 54 der Kleberschicht 28 abgezogen wird, bevor die Trägerschicht 30 von der Lasche 28 abgezogen wird. Dies erhöht die Zuverlässigkeit des Abziehens und minimiert eventuelle Rückstände der Trägerfolie 30 auf der Kleberschicht 28.

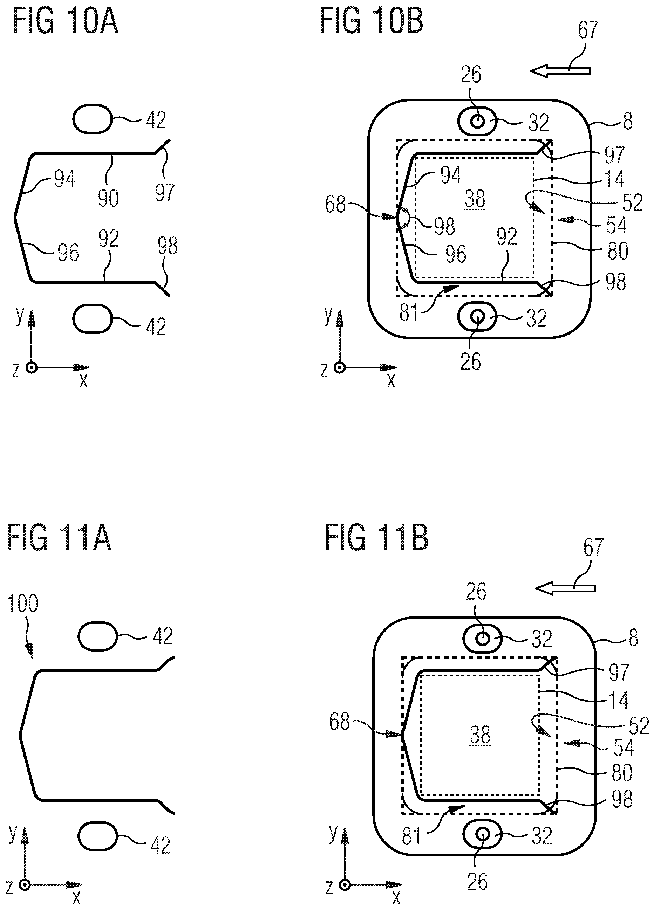

In Fig. 10A ist eine weitere bevorzugte Ausführungsform eines Schnitt- bzw. Stanzmusters dargestellt, umfassend die Schnittkanten 90, 92, 94, 96, 97, 98, und Fig. 10B zeigt eine entsprechende Kleberschicht 28 mit dem eingebrachten Stanzmuster der Fig. 10A. Hierbei verlaufen zwei Außenseiten 90, 92 der Lasche 38 parallel zu der Abziehrichtung 67 und an dem distalen Ende 68 der Lasche 38 ist ein durch zwei sich treffende Außenkanten 94, 96 gebildeter stumpfer Winkel 98 vorgesehen. An einem proximalen Ende 68 der Lasche 38 sind zwei gegenüber den restlichen Bereichen der Lasche 38 in Breitenrichtung vorstehende Außenkanten 97, 98 vorgesehen. Diese Außenkanten 97, 98 verlaufen wie die daran anschließenden Außenkanten 90, 92 der Lasche 38 in einem spitzen Winkel zur Abziehrichtung 67. Auch diese Ausführungsform stellt sicher, dass die Oberfläche 14 des Chipmoduls 8 vollständig von der Lasche 38 bedeckt wird, wenn die Kleberschicht 28 auf das Chipmodul 8 aufgebracht wird (siehe Fig. 10B).

Fig. 11A zeigt eine weitere bevorzugte Ausführungsform eines Schnitt- bzw. Stanzmusters 100 und Fig. 11B zeigt eine Kleberschicht 28 mit dem Stanzmuster 100 nach Fig. 11A. In diesem Fall sind im Vergleich zur Fig. 10B die beiden gegenüber den restlichen Bereichen der Lasche 38 in Breitenrichtung vorstehenden Außenkanten 97, 98 nicht linear, sondern gekrümmt geformt. Auch diese Ausführungsform stellt sicher, dass alle Tangenten der Außenkanten 97, 98 in einem spitzen Winkel zur Abziehrichtung 67 verlaufen und die erfindungsgemäßen Vorteile erreicht werden.

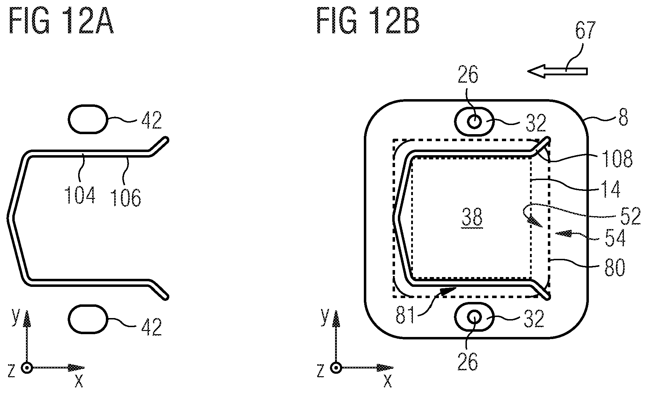

Fig. 12A zeigt eine weitere bevorzugte Ausführungsform eines Schnitt- bzw. Stanzmusters und Fig. 12B zeigt eine Kleberschicht 28 mit dem Stanzmuster aus Fig. 12A. Das Stanzmuster der Fig. 12A unterscheidet sich von dem Stanzmuster gemäß Fig. 11A darin, dass anstelle eines linienförmigen Stanzmusters 100 ein flächenförmiger Stanzmusterabschnitt 104 bzw. eine in sich geschlossene Stanzlinie 106 vorgesehen ist, welche die Form der Lasche 38 in der Kleberschicht 28 definiert. Mit anderen Worten werden sämtliche Außenkanten der Lasche 38 durch die Aussparung 108 gebildet, wobei die Aussparung 108 durch den Stanzmusterabschnitt 104 oder/und die Stanzlinie 106 in die Kleberschicht 28 eingebracht wird.

Die hierin beschriebenen Stanz- bzw. Schnittformen können zum Ausbilden der Laschen 38 in der Kleberschicht 28 verwendet werden. Nach dem Ausbilden der Laschen 38 können die Laschen 38 auf den Oberflächen 14 der betreffenden Chipmodule 8 des Modulträgerbands 12 befestigt werden. Die an die Laschen 38 angrenzenden Abschnitte 54 der Kleberfolie 28 werden dann auf den Oberflächen 16 der Basisbereiche 18 des Modulträgerbands 12 befestigt. Die Oberfläche 14 eines Chipmoduls 8 kann hierbei einen Oberflächenabschnitt umfassen, der gegenüber der Oberfläche 16 des umliegenden Basisbereichs 18 des Modulträgerbands 12 und verglichen mit allen anderen Abschnitten der Oberfläche 14 des Chipmoduls 8 am stärksten erhöht ist.

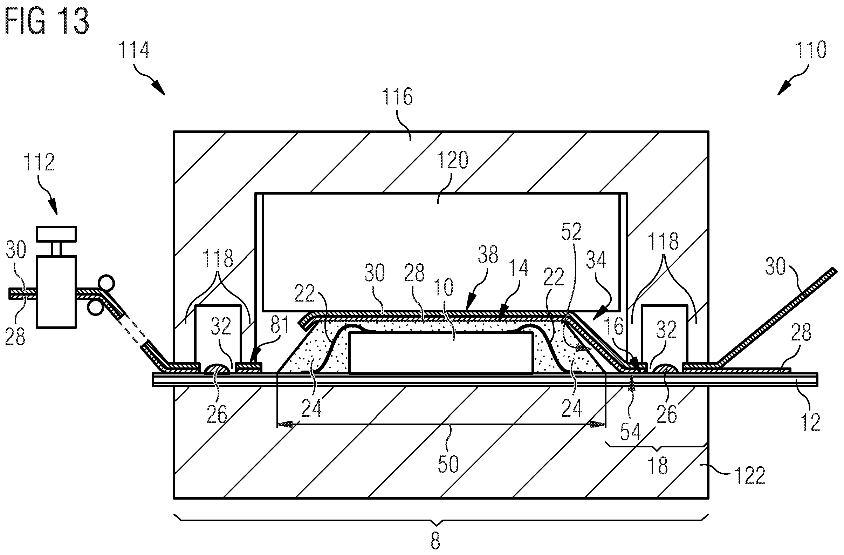

Fig. 13 zeigt schematisch eine Vorrichtung 110 zum Aufbringen einer Kleberschicht 28 auf ein mit einer Vielzahl von Chipmodulen 8 versehenes Modulträgerband 12 gemäß der vorliegenden Erfindung. Die Vorrichtung 110 umfasst hierzu eine Bearbeitungseinheit 112 und eine Verbindungseinheit 114.

Die Bearbeitungseinheit 112 ist zum Ausbilden von Laschen 38 in einer Kleberschicht 28 eingerichtet. Die Bearbeitungseinheit 112 umfasst insbesondere ein Stanz- oder Schneidwerkzeug, welches ein Stanz- oder Schnittmuster gemäß einer der Figuren 4A, 6A, 7A, 8A, 9A, 10A, 11A oder 12A in die Kleberschicht 28 einbringt, welche beispielsweise auf einer Trägerfolie 30 angeordnet ist.

Anschließend wird die Kleberschicht 28 mittels der Verbindungseinheit 114 modulweise oder anderweitig prozesstechnisch geeignet voranschreitend auf der Vielzahl von Chipmodulen 8 des betreffenden Modulträgerbands 12 angeordnet bzw. befestigt. Dazu umfasst die Verbindungseinheit 114 ein Fixierwerkzeug 116 mit Fixierelementen, die dazu ausgebildet sind, die Kleberfolie 28 geeignet platziert auf das Modulträgerband 12 aufzudrücken. Ferner umfasst das Fixierwerkzeug 116 einen flexiblen, wärmeleitenden Stempel 120, beispielsweise bestehend aus einem geeigneten Polymer, wie etwa Silikon. Der flexible Stempel 120 ist ausgebildet, die Laschen 38 jeweils auf die Oberflächen 14 der betreffenden Chipmodule 8 aufzudrücken, während simultan die Fixierelemente 118 die Kleberschicht 28 auf das Modulträgerband 12 aufdrücken. Während dem Aufdrücken werden vorzugsweise sowohl die Fixierelemente 118 als auch der Stempel 120 beheizt, um die Haftung der Kleberschicht 28 auf dem Chipmodul 8 zu bewirken oder zu optimieren.

Beispielsweise wird das Fixierwerkzeug 116 aktiv beheizt und der Stempel 120 leitet die Wärme an die Laschen 38 weiter. Das Modulträgerband 12 kann von dem Fixierwerkzeug 116 auf ein Gegenwerkzeug 122 gedrückt werden, so dass das Modulträgerband 12 und die Kleberschicht 28 zwischen dem Fixierwerkzeug 116 und dem Gegenwerkzeug 122 eingeklemmt werden. Dadurch wird die Kleberschicht 28 auf dem Modulträgerband 12 befestigt bzw. die als Transferschicht ausgebildete Kleberschicht 28 auf das Modulträgerband 12 übertragen.

Nach dem Verbinden der Kleberschicht 28 mit dem Chipmodul 8 bzw. mit dem Modulträgerband 12 insgesamt wird die Trägerfolie 30 von der Kleberschicht 28 in der zuvor beschriebenen Weise abgezogen. Hierbei wird die Trägerfolie 30 vorzugsweise derart abgezogen, dass sie zunächst von an die Laschen 38 angrenzenden Bereichen 54 der Kleberschicht 28 abgezogen wird, und erst anschließend von den Laschen 38 selbst. Zum Abziehen der Trägerfolie 30 kann die Vorrichtung 110 eine geeignete Abziehvorrichtung umfassen (nicht dargestellt). Alternativ kann auch die Verbindungseinheit 114 dazu eingerichtet sein, die Trägerfolie 30 abzuziehen.

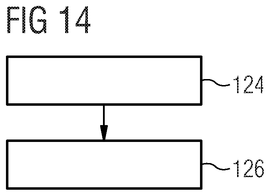

Fig. 14 zeigt das erfindungsgemäße Verfahren zum Aufbringen einer Kleberschicht 28 auf ein mit einer Vielzahl von Chipmodulen 8 versehenes Modulträgerband 12. In einem Schritt 124 werden Laschen 38 in der Kleberschicht 28 derart ausgebildet, dass die Laschen 38 mit den Chipmodulen 8 bzw. deren Vergußmassen 24 des Modulträgerbands 12 korrespondieren. Dabei werden die gestanzten Kontaktlöcher 32 so ausgerichtet, dass die jeweils die Kontakte 26 umschließen, wie etwa in den Fig. 4 und 6 bis 12 gezeigt. Im anschließenden Schritt 126 wird die Kleberschicht 28 mit dem Modulträgerband 12 derart verbunden, dass die Laschen 38 auf den Oberflächen 14 der Chipmodule 8 aufliegen und die an die Laschen 38 angrenzenden Abschnitte 54 der Kleberschicht 28 auf der Oberfläche 16 der umliegenden Basisbereiche 18 des Modulträgerbands 12 aufliegen. Das Verfahren kann ferner das Abziehen der Trägerfolie 30 von der Kleberschicht 28 nach dem Verbinden der Kleberschicht 28 mit dem Modulträgerband 12 umfassen.

Dieses Verfahren wird durch die Vorrichtung gemäß Fig. 13 ausgeführt. Hierbei werden insbesondere Laschen 38 ausgebildet, wie sie unter Bezugnahme auf die Figuren 4A bis 11B beschrieben werden.

Ein erfindungsgemäßes Verfahren zum Herstellen eines portablen Datenträgers 2, etwa eines Sicherheitsdokuments nach Fig. 1, umfasst zunächst den Schritt des Bereitstellens eines Datenträgerkörpers mit mindestens einer Kavität, die ein Chipmodul 8 vorzugsweise passgenau aufnehmen kann. Der Datenträgerkörper umfasst weiter elektrische Strukturen mit Kontakten, die zu dem Chipmodul 8 kontaktierbar sind. Das in die Kavität einzusetzende, mit einer Kleberschicht 28 versehene Chipmodul 8 wird bereitgestellt, indem es aus einem mit einer Kleberschicht 28 erfindungsgemäß versehenen Modulträgerband 12 geeignet vereinzelt wird. Dazu werden zum Beispiel aus dem mit der Kleberschicht 28 versehenen Modulträgerband 12 einzelne Chipmodule ausgestanzt oder anderweitig herausgetrennt, die im Wesentlichen passgenau in Kavitäten von Datenträgerkörpern hineinpassen. Das vereinzelte Chipmodul 8 wird schließlich mit dessen Klebeschicht 28 ins Innere der Kavität orientiert in den Datenträgerkörper eingesetzt, wobei eine etwaige Trägerfolie 30 bereits entfernt ist und die freiliegenden Kontaktelemente 26 des Chipmoduls 8 mit den in der Kavität vorgesehenen Kontakten der elektrischen Strukturen des Datenträgerkörpers kontaktieren.

Es versteht sich, dass die vorliegende Offenbarung nicht auf die einzelnen hierin beschriebenen Ausführungsformen beschränkt ist. Kombinationen einzelner Merkmale mehrerer Ausführungsformen sind möglich. So ist es zum Beispiel denkbar, einzelne Merkmale von zwei oder drei Schnittmustern zu kombinieren, um ein neues vorteilhaftes Schnittmuster zu bilden. Auch andere Merkmalskombinationen sind denkbar. Die zu den Ausführungsformen beschriebenen Merkmale sind, sofern nicht in den unabhängigen Ansprüchen anderweitig definiert, als optional zu betrachten.

## Patentansprüche

1. Verfahren zum Aufbringen einer Kleberschicht (28) auf ein mit einer Vielzahl von Chipmodulen (8) versehenes Modulträgerband (12), wobei Oberflächen (14) der Chipmodule (8) gegenüber der Oberfläche (16) von die Vielzahl von Chipmodulen (8) umschließenden Basisbereichen (18) des Modulträgerbands (12) erhöht sind, wobei das Verfahren die folgenden Schritte umfasst:
- Ausbilden (124) von Laschen (38) in der Kleberschicht (28) derart, dass die Laschen (38) mit Chipmodulen (8) des Modulträgerbands (12) korrespondieren;
- Verbinden (126) der Kleberschicht (28) mit dem Modulträgerband (12) derart, dass die Laschen (38) auf den Oberflächen (14) der Chipmodule (8) aufliegen und an die Laschen (38) angrenzende Abschnitte (54) der Kleberschicht (28) auf den Basisbereichen (18) des Modulträgerbands (12) aufliegen.

2. Verfahren nach Anspruch 1, ferner umfassend den Schritt des Ausbildens von Kontaktaussparungen (32) in der Kleberschicht (28) derart, dass die Kontaktaussparungen (32) beim Verbinden (126) der Kleberschicht (28) mit dem Modulträgerband (12) elektrische Kontaktelemente (26) der Chipmodule (8) umschließen, so dass die Kontaktelemente (26) von der Kleberschicht (28) unbedeckt bleiben.

3. Verfahren nach Anspruch 1 oder 2, wobei die Laschen (38) durch Einbringen von Aussparungen (56, 66, 108) in der Kleberschicht ausgebildet werden und/oder durch Schnittmuster (44, 74) derart in der Kleberschicht (28) ausgebildet werden, dass sich die Schnittmuster (44, 74) beim Verbinden der Kleberschicht (28) mit dem Modulträgerband (12) derart zu Aussparungen (56, 66, 108) aufweiten, dass die an die Laschen (38) angrenzenden Abschnitte (54) der Kleberschicht (28) auf den Basisbereichen (18) des Modulträgerbands (12) aufliegen.

4. Verfahren nach Anspruch 3, wobei sich die Schnittmuster (44, 74) beim Verbinden der Kleberschicht (28) derart zu Aussparungen (56, 66, 108) aufweiten, dass die Kleberschicht (28) auf Flanken (34) der Chipmodule (8) aufliegt, die Übergänge von den Oberflächen (14) der Chipmodule (8) zur Oberfläche (16) der Basisbereiche (18) des Modulträgerbands (12) bilden.

5. Verfahren nach einem der Ansprüche 1 bis 4, wobei die Kleberschicht (28) beim Ausbilden der Laschen (38) als Transferschicht auf einer Trägerfolie (30) angeordnet ist, und wobei das Verfahren ferner den Schritt des Abziehens der Trägerfolie (30) in einer Abziehrichtung (67) von der Kleberschicht (28) nach dem Verbinden (126) der Kleberschicht (28) mit dem Substrat (12) umfasst.

6. Verfahren nach Anspruch 5, wobei die auf den Chipmodulen (8) jeweils aufliegenden Laschen (38) mit ihren distalen Enden (68) in jeweils eine vorbestimmte Richtung weisen, wobei
(i) die vorbestimmte Richtung orthogonal zu der Abziehrichtung (67) ist oder
(ii) die vorbestimmte Richtung in einem spitzen Winkel zur Abziehrichtung verläuft oder
(iii) die vorbestimmte Richtung der Abziehrichtung (67) entspricht.

7. Verfahren nach Anspruch 5 oder 6, wobei die auf den Chipmodulen (8) aufliegenden Laschen (38) jeweils Außenkanten (90-98) aufweisen, die
(i) parallel zur Abziehrichtung (67) verlaufen;
(ii) in einem stumpfen Winkel zur Abziehrichtung (67) verlaufen;
(iii) die gekrümmt verlaufen, wobei Tangenten der Außenkanten (90-98) parallel oder in einem spitzen Winken zur Abziehrichtung (67) verlaufen.

8. Verfahren nach einem der vorhergehenden Ansprüche, wobei die Laschen (38) spiegelsymmetrisch ausgebildet werden.

9. Verfahren nach einem der vorherigen Ansprüche, wobei die Kleberschicht (28) derart mit dem Modulträgerband (12) verbunden wird, dass von der Kleberschicht (28) nur die Laschen (38) auf den Oberflächen (14) der jeweiligen Chipmodule (8) aufliegen und diese vollständig bedecken und/oder die Laschen (38) auch auf Flanken (34) der Chipmodule (8) aufliegen, wobei die Flanken (34) Übergänge von den Oberflächen (14) der Chipmodule (8) zur Oberfläche (16) der Basisbereiche (18) des Modulträgerbands (12) bilden.

10. Verfahren nach einem der vorhergehenden Ansprüche, wobei bei dem Verbinden (126) der Kleberschicht (28) mit dem Modulträgerband (12) die Laschen (38) auf die Oberfläche (14) der Chipmodule (8) aufgepresst werden, wobei gleichzeitig die an die Laschen (38) angrenzenden Abschnitte (54) der Kleberschicht (28) jeweils auf die Oberfläche (16) des Basisbereichs (18) des Modulträgerbands (12) und/oder Flanken (34) der Chipmodule (8) aufgepresst werden, wobei die Flanken (34) Übergänge von den Oberflächen (14) der Chipmodule (8) zur Oberfläche (16) der Basisbereiche (18) des Modulträgerbands (12) bilden.

11. Vorrichtung (110) zum Aufbringen einer Kleberschicht (28) auf ein mit einer Vielzahl von Chipmodulen (8) versehenes Modulträgerband (12), umfassend:
eine Bearbeitungseinheit (112), die eingerichtet ist, in der Kleberschicht (28) Laschen (38) derart auszubilden, dass die Laschen (38) mit den Chipmodulen (8) des Modulträgerbands (12) korrespondieren,
eine Verbindungseinheit (114), die eingerichtet ist, die Kleberschicht (28) derart mit dem Modulträgerband (12) zu verbinden, dass die Laschen (38) auf Oberflächen (14) der Chipmodule (8) aufliegen, die gegenüber der Oberfläche (16) von die Vielzahl von Chipmodulen (8) umschließenden Basisbereichen (18) des Modulträgerbands (12) erhöht sind, und an die Laschen (38) angrenzende Abschnitte (54) der Kleberschicht (28) auf den Basisbereichen (18) des Modulträgerbands (12) aufliegen.

12. Vorrichtung (110) nach Anspruch 11, umfassend einen wärmeleitenden Stempel (120), der eingerichtet ist, die Laschen (38) auf die Oberflächen (14) der Chipmodule (8) aufzupressen und die an die Laschen (38) angrenzenden Abschnitte (54) der Kleberschicht (28) auf die Basisbereiche (18) des Modulträgerbands (12) aufzupressen.

13. Mit einer Kleberschicht (28) verbundenes Modulträgerband (12),
wobei das Modulträgerband (12) mit einer Vielzahl von Chipmodulen (8) versehen ist und Oberflächen (14) der Chipmodule (8) gegenüber der Oberfläche (16) von die Vielzahl von Chipmodulen (8) umschließenden Basisbereichen (18) des Modulträgerbands (12) erhöht sind, und
die Kleberschicht (28) Laschen (38) umfasst, die mit den Chipmodulen (8) des Modulträgerbands (12) korrespondieren, und derart mit dem Modulträgerband (12) verbunden sind, dass die Laschen (38) auf den Oberflächen (14) der Chipmodule (8) aufliegen und an die Laschen (38) angrenzende Abschnitte (54) der Kleberschicht (28) auf den Basisbereichen (18) des Modulträgerbands (12) aufliegen.

14. Kleberschicht (28) zur Aufbringung auf ein mit einer Vielzahl von Chipmodulen (8) versehenes Modulträgerband (12),
wobei die Kleberschicht (28) Laschen (38) umfasst und dazu ausgebildet ist, mit dem Modulträgerband (12) derart verbunden zu werden, dass die Laschen (38) auf Oberflächen (14) der Chipmodule (8) aufliegen und an die Laschen (38) angrenzende Abschnitte (54) der Kleberschicht (28) auf die Chipmodule (8) umschließenden Basisbereichen (18) des Modulträgerbands (12) aufliegen,
wobei die Laschen (38) vorzugsweise durch in die Kleberschicht (28) eingebrachte Schnittmuster (44, 74) ausgebildet sind, die sich beim Verbinden mit dem Modulträgerband (12) derart zu Aussparungen aufweiten, dass die an die Laschen (38) angrenzenden Abschnitte (54) der Kleberschicht (28) auf den Basisbereichen (18) des Modulträgerbands (12) aufliegen.

15. Verfahren zum Herstellen eines portablen Datenträgers (2) umfassend ein Chipmodul (8), umfassend die Schritte:
- Bereitstellen eines Datenträgerkörpers (2) umfassend elektrische Strukturen mit Kontakten, die über eine Kavität des Datenträgerkörpers (2) kontaktierbar sind, wobei die Kavität eingerichtet ist, das Chipmodul (8) aufzunehmen;
- Bereitstellen eines mit einer Kleberschicht (28) versehenen Modulträgerbands (12) gemäß Anspruch 13;
- Vereinzeln des Chipmoduls (8) aus dem mit der Kleberschicht (28) versehenen Modulträgerband (12);
- Einsetzen des vereinzelten Chipmoduls (8) in die Kavität des Datenträgerkörpers (2) derart, dass das Chipmodul (8) die Kontakte der elektrischen Strukturen kontaktiert.

16. Portabler Datenträger (2), hergestellt gemäß einem Verfahren nach Anspruch 15.

## Claims

1. A method for applying an adhesive layer (28) to a module carrier tape (12) provided with a plurality of chip modules (8), wherein surfaces (14) of the chip modules (8) are elevated with respect to the surface (16) of base regions (18) of the module carrier tape (12) enclosing the plurality of chip modules (8), wherein the method comprises the following steps:
- forming (124) tabs (38) in the adhesive layer (28) such that the tabs (38) correspond to chip modules (8) of the module carrier tape (12);
- connecting (126) the adhesive layer (28) to the module carrier tape (12) such that the tabs (38) rest on the surfaces (14) of the chip modules (8) and portions (54) of the adhesive layer (28) adjacent to the tabs (38) rest on the base regions (18) of the module carrier tape (12).

2. The method according to claim 1, further comprising the step of forming contact recesses (32) in the adhesive layer (28) such that the contact recesses (32) enclose electrical contact elements (26) of the chip modules (8) when connecting (126) the adhesive layer (28) to the module carrier tape (12), so that the contact elements (26) remain uncovered by the adhesive layer (28).

3. The method according to claim 1 or 2, wherein the tabs (38) are formed by introducing recesses (56, 66, 108) in the adhesive layer and/or are formed by cutting patterns (44, 74) in the adhesive layer (28) such that the cutting patterns (44, 74) widen to form recesses (56, 66, 108) when connecting the adhesive layer (28) to the module carrier tape (12) such that the portions (54) of the adhesive layer (28) adjacent to the tabs (38) rest on the base regions (18) of the module carrier tape (12).

4. The method according to claim 3, wherein the cutting patterns (44, 74) widen to form recesses (56, 66, 108) when connecting the adhesive layer (28) such that the adhesive layer (28) rests on flanks (34) of the chip modules (8) which form transitions from the surfaces (14) of the chip modules (8) to the surface (16) of the base regions (18) of the module carrier tape (12).

5. The method according to any one of claims 1 to 4, wherein the adhesive layer (28) is arranged as a transfer layer on a carrier film (30) when forming the tabs (38), and wherein the method further comprises the step of peeling the carrier film (30) in a peeling direction (67) from the adhesive layer (28) after connecting (126) the adhesive layer (28) to the substrate (12).

6. The method according to claim 5, wherein the tabs (38) respectively resting on the chip modules (8) each point with their distal ends (68) in a predetermined direction, wherein
(i) the predetermined direction is orthogonal to the peeling direction (67) or
(ii) the predetermined direction runs at an acute angle to the peeling direction or
(iii) the predetermined direction corresponds to the peeling direction (67).

7. The method according to claim 5 or 6, wherein the tabs (38) resting on the chip modules (8) each have outer edges (90-98) which
(i) run parallel to the peeling direction (67);
(ii) run at an obtuse angle to the peeling direction (67);
(iii) run in a curved manner, wherein tangents of the outer edges (90-98) run parallel or at an acute angle to the peeling direction (67).

8. The method according to one of the preceding claims, wherein the tabs (38) are of mirror-symmetrical design.

9. The method according to one of the preceding claims, wherein the adhesive layer (28) is connected to the module carrier tape (12) such that, of the adhesive layer (28), only the tabs (38) rest on the surfaces (14) of the respective chip modules (8) and completely cover the latter and/or the tabs (38) also rest on flanks (34) of the chip modules (8), wherein the flanks (34) form transitions from the surfaces (14) of the chip modules (8) to the surface (16) of the base regions (18) of the module carrier tape (12).

10. The method according to one of the preceding claims, wherein, when connecting (126) the adhesive layer (28) to the module carrier tape (12), the tabs (38) are pressed onto the surface (14) of the chip modules (8), wherein at the same time the portions (54) of the adhesive layer (28) adjacent to the tabs (38) are each pressed onto the surface (16) of the base region (18) of the module carrier tape (12) and/or flanks (34) of the chip modules (8), wherein the flanks (34) form transitions from the surfaces (14) of the chip modules (8) to the surface (16) of the base regions (18) of the module carrier tape (12).

11. A device (110) for applying an adhesive layer (28) to a module carrier tape (12) provided with a plurality of chip modules (8), comprising:
a processing unit (112) which is configured to form tabs (38) in the adhesive layer (28) such that the tabs (38) correspond to the chip modules (8) of the module carrier tape (12),
a connecting unit (114) which is configured to connect the adhesive layer (28) to the module carrier tape (12) such that the tabs (38) rest on surfaces (14) of the chip modules (8) which are elevated with respect to the surface (16) of base regions (18) of the module carrier tape (12) enclosing the plurality of chip modules (8), and portions (54) of the adhesive layer (28) adjacent to the tabs (38) rest on the base regions (18) of the module carrier tape (12).

12. The device (110) according to claim 11, comprising a heat-conducting stamp (120) which is configured to press the tabs (38) onto the surfaces (14) of the chip modules (8) and to press the portions (54) of the adhesive layer (28) adjacent to the tabs (38) onto the base regions (18) of the module carrier tape (12).

13. A module carrier tape (12) connected to an adhesive layer (28),
wherein the module carrier tape (12) is provided with a plurality of chip modules (8) and surfaces (14) of the chip modules (8) are elevated with respect to the surface (16) of base regions (18) of the module carrier tape (12) enclosing the plurality of chip modules (8), and
the adhesive layer (28) comprises tabs (38) which correspond to the chip modules (8) of the module carrier tape (12) and are connected to the module carrier tape (12) such that the tabs (38) rest on the surfaces (14) of the chip modules (8) and portions (54) of the adhesive layer (28) adjacent to the tabs (38) rest on the base regions (18) of the module carrier tape (12).

14. An adhesive layer (28) for application to a module carrier tape (12) provided with a plurality of chip modules (8),
wherein the adhesive layer (28) comprises tabs (38) and is designed to be connected to the module carrier tape (12) such that the tabs (38) rest on surfaces (14) of the chip modules (8) and portions (54) of the adhesive layer (28) adjacent to the tabs (38) rest on base regions (18) of the module carrier tape (12) enclosing the chip modules (8),
wherein the tabs (38) are preferably formed by cutting patterns (44, 74) introduced into the adhesive layer (28) which widen to form recesses when connecting to the module carrier tape (12) such that the portions (54) of the adhesive layer (28) adjacent to the tabs (38) rest on the base regions (18) of the module carrier tape (12).

15. A method for producing a portable data carrier (2) comprising a chip module (8), comprising the steps:
- providing a data carrier body (2) comprising electrical structures with contacts which can be contacted via a cavity of the data carrier body (2), wherein the cavity is configured to receive the chip module (8);
- providing a module carrier tape (12) provided with an adhesive layer (28) according to claim 13;
- singulating the chip module (8) from the module carrier tape (12) provided with the adhesive layer (28);
- inserting the singulated chip module (8) into the cavity of the data carrier body (2) such that the chip module (8) contacts the contacts of the electrical structures.

16. A portable data carrier (2) produced according to a method according to claim 15.

## Revendications

1. Procédé d'application d'une couche adhésive (28) sur une bande de support de module (12) pourvue d'une pluralité de modules de puce (8), dans lequel des surfaces (14) des modules de puce (8) sont surélevées par rapport à la surface (16) de zones de base (18) de la bande de support de module (12) entourant la pluralité de modules de puce (8), le procédé comprenant les étapes suivantes:
- formation (124) de languettes (38) dans la couche adhésive (28) de telle sorte que les languettes (38) correspondent à des modules de puce (8) de la bande de support de module (12);
- liaison (126) de la couche adhésive (28) à la bande de support de module (12) de telle sorte que les languettes (38) reposent sur les surfaces (14) des modules de puce (8) et que des parties (54) de la couche adhésive (28) adjacentes aux languettes (38) reposent sur les zones de base (18) de la bande de support de module (12).

2. Procédé selon la revendication 1, comprenant en outre l'étape de formation d'évidements de contact (32) dans la couche adhésive (28) de telle sorte que les évidements de contact (32), lors de la liaison (126) de la couche adhésive (28) à la bande de support de module (12), entourent des éléments de contact électriques (26) des modules de puce (8) de telle sorte que les éléments de contact (26) restent non recouverts par la couche adhésive (28).

3. Procédé selon la revendication 1 ou 2, dans lequel les languettes (38) sont formées par introduction d'évidements (56, 66, 108) dans la couche adhésive et/ou sont formées par des motifs de coupe (44, 74) dans la couche adhésive (28) de telle sorte que les motifs de coupe (44, 74), lors de la liaison de la couche adhésive (28) à la bande de support de module (12), s'élargissent en évidements (56, 66, 108) de telle sorte que les parties (54) de la couche adhésive (28) adjacentes aux languettes (38) reposent sur les zones de base (18) de la bande de support de module (12).

4. Procédé selon la revendication 3, dans lequel les motifs de coupe (44, 74), lors de la liaison de la couche adhésive (28), s'élargissent en évidements (56, 66, 108) de telle sorte que la couche adhésive (28) repose sur des flancs (34) des modules de puce (8) qui forment des transitions des surfaces (14) des modules de puce (8) à la surface (16) des zones de base (18) de la bande de support de module (12).

5. Procédé selon l'une quelconque des revendications 1 à 4, dans lequel la couche adhésive (28), lors de la formation des languettes (38), est disposée en tant que couche de transfert sur une feuille de support (30), et dans lequel le procédé comprend en outre l'étape de retrait de la feuille de support (30) dans une direction de retrait (67) de la couche adhésive (28) après la liaison (126) de la couche adhésive (28) au substrat (12).

6. Procédé selon la revendication 5, dans lequel les languettes (38) reposant à chaque fois sur les modules de puce (8) sont tournées avec leurs extrémités distales (68) à chaque fois dans une direction prédéfinie, dans lequel
(i) la direction prédéfinie est orthogonale à la direction de retrait (67) ou
(ii) la direction prédéfinie s'étend selon un angle aigu par rapport à la direction de retrait ou
(iii) la direction prédéfinie correspond à la direction de retrait (67).

7. Procédé selon la revendication 5 ou 6, dans lequel les languettes (38) reposant sur les modules de puce (8) présentent à chaque fois des arêtes extérieures (90-98) qui
(i) s'étendent parallèlement à la direction de retrait (67);
(ii) s'étendent selon un angle obtus par rapport à la direction de retrait (67);
(iii) s'étendent de manière courbe, dans lequel des tangentes des arêtes extérieures (90-98) s'étendent parallèlement ou selon un angle aigu par rapport à la direction de retrait (67).

8. Procédé selon l'une quelconque des revendications précédentes, dans lequel les languettes (38) sont réalisées avec une symétrie spéculaire.

9. Procédé selon l'une quelconque des revendications précédentes, dans lequel la couche adhésive (28) est reliée à la bande de support de module (12) de telle sorte que parmi la couche adhésive (28), seules les languettes (38) reposent sur les surfaces (14) des modules de puce (8) respectifs et recouvrent complètement celles-ci et/ou les languettes (38) reposent également sur des flancs (34) des modules de puce (8), dans lequel les flancs (34) forment des transitions des surfaces (14) des modules de puce (8) à la surface (16) des zones de base (18) de la bande de support de module (12).

10. Procédé selon l'une quelconque des revendications précédentes, dans lequel, lors de la liaison (126) de la couche adhésive (28) à la bande de support de module (12), les languettes (38) sont pressées sur la surface (14) des modules de puce (8), dans lequel en même temps les parties (54) de la couche adhésive (28) adjacentes aux languettes (38) sont pressées à chaque fois sur la surface (16) de la zone de base (18) de la bande de support de module (12) et/ou des flancs (34) des modules de puce (8), dans lequel les flancs (34) forment des transitions des surfaces (14) des modules de puce (8) à la surface (16) des zones de base (18) de la bande de support de module (12).

11. Dispositif (110) d'application d'une couche adhésive (28) sur une bande de support de module (12) pourvue d'une pluralité de modules de puce (8), comprenant:
une unité de traitement (112) qui est conçue pour former des languettes (38) dans la couche adhésive (28) de telle sorte que les languettes (38) correspondent aux modules de puce (8) de la bande de support de module (12),
une unité de liaison (114) qui est conçue pour relier la couche adhésive (28) à la bande de support de module (12) de telle sorte que les languettes (38) reposent sur des surfaces (14) des modules de puce (8) qui sont surélevées par rapport à la surface (16) de zones de base (18) de la bande de support de module (12) entourant la pluralité de modules de puce (8) et que des parties (54) de la couche adhésive (28) adjacentes aux languettes (38) reposent sur les zones de base (18) de la bande de support de module (12).

12. Dispositif (110) selon la revendication 11, comprenant un poinçon thermoconducteur (120) qui est conçu pour presser les languettes (38) sur les surfaces (14) des modules de puce (8) et pour presser les parties (54) de la couche adhésive (28) adjacentes aux languettes (38) sur les zones de base (18) de la bande de support de module (12).

13. Bande de support de module (12) reliée à une couche adhésive (28),
dans laquelle la bande de support de module (12) est pourvue d'une pluralité de modules de puce (8) et des surfaces (14) des modules de puce (8) sont surélevées par rapport à la surface (16) de zones de base (18) de la bande de support de module (12) entourant la pluralité de modules de puce (8), et
la couche adhésive (28) comprend des languettes (38) qui correspondent aux modules de puce (8) de la bande de support de module (12) et qui sont reliées à la bande de support de module (12) de telle sorte que les languettes (38) reposent sur les surfaces (14) des modules de puce (8) et que des parties (54) de la couche adhésive (28) adjacentes aux languettes (38) reposent sur les zones de base (18) de la bande de support de module (12).

14. Couche adhésive (28) destinée à être appliquée sur une bande de support de module (12) pourvue d'une pluralité de modules de puce (8),
dans laquelle la couche adhésive (28) comprend des languettes (38) et est conçue pour être reliée à la bande de support de module (12) de telle sorte que les languettes (38) reposent sur des surfaces (14) des modules de puce (8) et que des parties (54) de la couche adhésive (28) adjacentes aux languettes (38) reposent sur des zones de base (18) de la bande de support de module (12) entourant les modules de puce (8),
dans laquelle les languettes (38) sont formées de préférence par des motifs de coupe (44, 74) introduits dans la couche adhésive (28) qui, lors de la liaison à la bande de support de module (12), s'élargissent en évidements de telle sorte que les parties (54) de la couche adhésive (28) adjacentes aux languettes (38) reposent sur les zones de base (18) de la bande de support de module (12).

15. Procédé de fabrication d'un support de données portable (2) comprenant un module de puce (8), comprenant les étapes suivantes:
- fourniture d'un corps de support de données (2) comprenant des structures électriques avec des contacts qui peuvent être mis en contact par le biais d'une cavité du corps de support de données (2), dans lequel la cavité est conçue pour recevoir le module de puce (8);
- fourniture d'une bande de support de module (12) pourvue d'une couche adhésive (28) selon la revendication 13;
- séparation du module de puce (8) de la bande de support de module (12) pourvue de la couche adhésive (28) ;
- insertion du module de puce séparé (8) dans la cavité du corps de support de données (2) de telle sorte que le module de puce (8) entre en contact avec les contacts des structures électriques.

16. Support de données portable (2), fabriqué selon un procédé selon la revendication 15.
